(19) **Europäisches Patentamt / European Patent Office / Office européen des brevets**

(11) **EP 4 123 322 B1**

(12) **EUROPEAN PATENT SPECIFICATION**

(45) Date of publication and mention
of the grant of the patent:
**03.09.2025  Bulletin 2025/36**

(21) Application number: **20922500.2**

(22) Date of filing: **16.03.2020**

(51) International Patent Classification (IPC):
**G01R 31/3842** (2019.01)   **G01R 31/388** (2019.01)
**G01R 31/392** (2019.01)

(52) Cooperative Patent Classification (CPC):
**G01R 31/392;** Y02E 60/10; Y02T 90/167;
Y04S 30/12

(86) International application number:
**PCT/JP2020/011548**

(87) International publication number:
**WO 2021/186512 (23.09.2021 Gazette 2021/38)**

(54) **INFORMATION PROCESSING DEVICE, INFORMATION PROCESSING METHOD, COMPUTER PROGRAM AND INFORMATION PROCESSING SYSTEM**

INFORMATIONSVERARBEITUNGSVORRICHTUNG,
INFORMATIONSVERARBEITUNGSVERFAHREN, COMPUTERPROGRAMM UND
INFORMATIONSVERARBEITUNGSSYSTEM

DISPOSITIF DE TRAITEMENT D'INFORMATIONS, PROCÉDÉ DE TRAITEMENT
D'INFORMATIONS, PROGRAMME D'ORDINATEUR ET SYSTÈME DE TRAITEMENT
D'INFORMATIONS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.01.2023  Bulletin 2023/04**

(73) Proprietor: **KABUSHIKI KAISHA TOSHIBA**
**Minato-ku**
**Tokyo 105-0023 (JP)**

(72) Inventors:
• **MARUCHI, Kohei**
  **Tokyo 105-0023 (JP)**
• **YAMAMOTO, Takahiro**
  **Tokyo 105-0023 (JP)**
• **HATANO, Hisaaki**
  **Tokyo 105-0023 (JP)**
• **FUJIWARA, Kenichi**
  **Tokyo 105-0023 (JP)**

• **KOIWA, Kaoru**
  **Tokyo 105-0023 (JP)**
• **TATEBAYASHI, Yoshinao**
  **Tokyo 105-0023 (JP)**
• **TAKAZAWA, Koji**
  **Tokyo 105-0023 (JP)**

(74) Representative: **Hoffmann Eitle**
**Patent- und Rechtsanwälte PartmbB**
**Arabellastraße 30**
**81925 München (DE)**

(56) References cited:
WO-A1-2014/045706      WO-A1-2016/147572
WO-A1-2017/104497      WO-A1-2018/181620
JP-A- 2012 208 027      JP-A- 2015 230 193
JP-A- 2016 114 469      JP-A- 2016 114 469
JP-A- 2017 223 454      JP-A- 2019 219 193
US-A1- 2017 146 609      US-A1- 2017 279 171
US-A1- 2019 181 510

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

[Technical Field]

Embodiments described herein relate to an information processing apparatus, an information processing method, a computer program and an information processing system.

[Background Art]

There is increasing use of rechargeable batteries (secondary batteries) such as in order for stabilization of electric power systems and reduction of exhaust gas. On the other hand, it is required to monitor a state of the rechargeable battery, e.g., the degradation state of the rechargeable battery in order to avoid sudden failure of the battery system.

There are a technique of evaluating the degradation state of the rechargeable battery based on data obtained from the rechargeable battery when a special charge/discharge process is performed and a technique of evaluating the degradation state of the rechargeable battery with an approximation equation (e.g., the Arrhenius approximation equation) such as based on the number of charge/discharge cycles.

Also, as a technique for on-line evaluation of the degradation state of the rechargeable battery, there is a technique of evaluating the degradation state of the rechargeable battery based on data obtained during normal operation of the rechargeable battery. In this technique, there is no need to stop the operation of the rechargeable battery. However, it is necessary to collect a lot of operation data suitable for evaluation in order to evaluate the degradation state of the rechargeable battery.

Patent Literature 2 relates to a secondary battery system and method of estimating stress of active material of a secondary battery.

[Citation List]

[Patent Literature]

     Patent Literature 1: Publication of Japanese Patent No. 6313502
     Patent Literature 2: US 2019/0181510 A1

[Summary of Invention]

[Technical Problem]

The present embodiments provide an information processing apparatus, an information processing method, a computer program and an information processing system for evaluating a state of a rechargeable battery.

[Solution to Problem]

The present invention is defined by the independent claims. Preferred embodiments are defined by the dependent claims. Further aspects are provided for facilitating the understanding of the invention.

[Brief Description of Drawings]

     FIG. 1 is a block diagram of a rechargeable battery evaluation system according to a first embodiment;
     FIG. 2 shows an example configuration of a rechargeable battery;
     FIG. 3 shows an example configuration of one module;
     FIG. 4 shows an example of an operation data DB;
     FIG. 5 schematically shows an example of an OCV curve;
     FIG. 6 shows an example in which an OCV graph is calculated by linear regression;
     FIG. 7 shows an example in which corrected voltage values corresponding to the difference between voltage values and OCV are plotted;
     FIG. 8 shows an example of output of an evaluation result;
     FIG. 9 shows an example of an evaluation result displayed on a display device of an EV;
     FIG. 10 is a flow chart of an example of operations of a rechargeable battery evaluation apparatus according to the first embodiment;
     FIG. 11 is an illustrative diagram of the present variation;
     FIG. 12 is a block diagram of a rechargeable battery evaluation apparatus according to a second embodiment;
     FIG. 13 shows an example of training data stored in a reference DB;
     FIG. 14 shows an example of training data stored in the reference DB;
     FIG. 15 shows an example of data in which a measured voltage monotonously increases;
     FIG. 16 shows an example of a capacity measurement DB;
     FIG. 17 shows an example of the difference between estimated SoH and measured SoH;
     FIG. 18 is a flow chart showing an example of processes of an evaluation function generator;
     FIG. 19 is a flow chart of an example of processes of a measurement target data extractor and an evaluation function updater;
     FIG. 20 is a block diagram of a rechargeable battery evaluation system according to a third embodiment;
     FIG. 21 is a flow chart of an example of operations of a rechargeable battery evaluation apparatus according to the third embodiment;
FIG. 22 is a block diagram of a rechargeable battery evaluation system according to a fourth embodiment;
FIG. 23 is a flow chart of an example of operations of a rechargeable battery evaluation apparatus according to the fourth embodiment;
FIG. 24 is a block diagram of a rechargeable battery evaluation system according to a fifth embodiment;
FIG. 25 shows an example internal configuration of a rechargeable battery;
FIG. 26 shows an example in which the rechargeable battery evaluation system according to the first embodiment is provided with a moving vehicle;
FIG. 27 shows an example in which the rechargeable battery evaluation system is distributed over a moving vehicle and an evaluation server;
FIG. 28 shows another example in which the rechargeable battery evaluation system is distributed over a moving vehicle and an evaluation server;
FIG. 29 shows another example in which the rechargeable battery evaluation system is distributed over a moving vehicle, a management server and an evaluation server;
FIG. 30 shows an example of a management DB; and
FIG. 31 shows an example hardware configuration of a rechargeable battery evaluation apparatus.

[Description of Embodiments]

Embodiments of the present invention will be described below with reference to the drawings.

(First Embodiment)

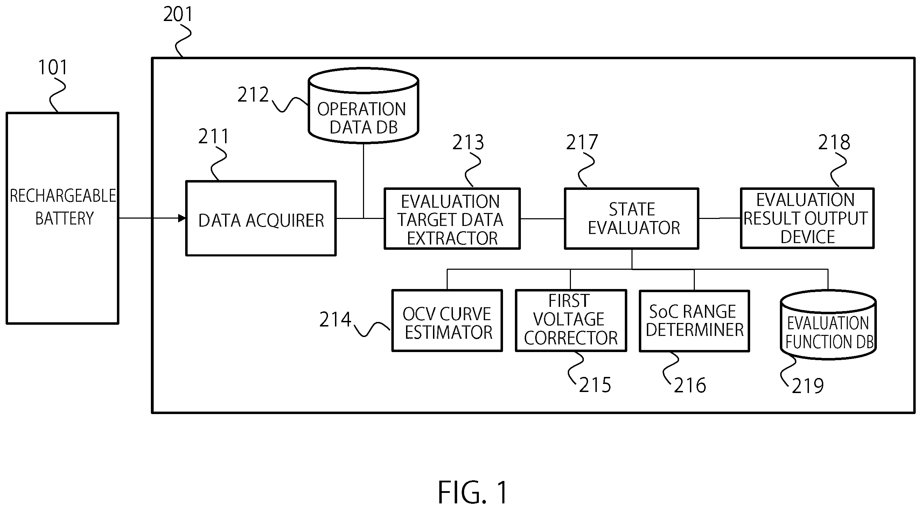

FIG. 1 is a block diagram of a rechargeable battery evaluation system according to a first embodiment. The rechargeable battery evaluation system in FIG. 1 includes a rechargeable battery 101 and a rechargeable battery evaluation apparatus 201, which is an information processing apparatus according to the first embodiment. The rechargeable battery evaluation apparatus 201 includes a data acquirer 211, an operation data DB 212, an evaluation target data extractor 213, an OCV curve estimator (relationship information generator) 214, a voltage corrector (first voltage corrector) 215, an SoC range determiner (range determiner) 216, a state evaluator 217, an evaluation result output device 218 and an evaluation function DB 219.

The rechargeable battery 101 is a battery capable of charge/discharge. The rechargeable battery 101 is also referred to as a secondary battery, but will hereinafter be uniformly referred to as a rechargeable battery. In the present embodiment, a reference to charge/-discharge includes at least one of charge and discharge.

As an example, the rechargeable battery 101 is a battery provided with a moving vehicle that operates with electric energy as a power source, such as an Electric Vehicle (EV), an electric bus, an electric train, a Light Rail Transit (LRT) system, a Bus Rapid Transit (BRT) system, an Automatic Guided Vehicle (AGV), an airplane or a ship. Alternatively, the rechargeable battery 101 may be a rechargeable battery provided with electric equipment (such as a smartphone or a personal computer), a rechargeable battery that stores electric power for the demand response purpose, or the like. The rechargeable battery 101 may also be a rechargeable battery for other purposes.

The rechargeable battery 101 can be charged by a charger disposed at a charging station, a road shoulder, a parking lot or the like or a charger connected to a receptacle or the like. It may also be possible to perform discharge of electric power accumulated in the rechargeable battery 101 into an electric power system via the charger (reverse power flow). The scheme for transmitting electric power from the charger to the rechargeable battery 101 may be either a contact charging scheme or a contactless charging scheme.

The rechargeable battery 101 includes a plurality of battery units. The plurality of battery units are connected in series or parallel. Alternatively, the plurality of battery units are connected in series and parallel.

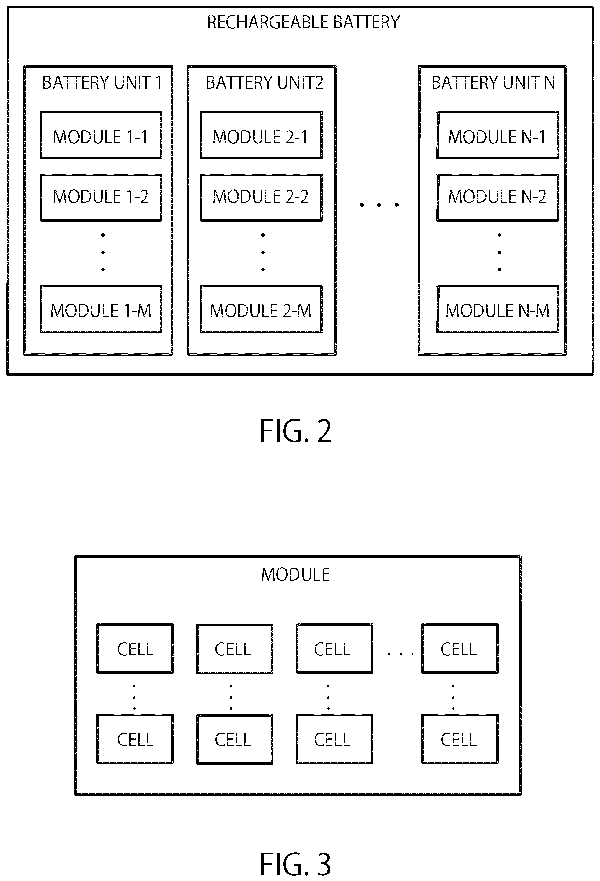

FIG. 2 shows an example configuration of the rechargeable battery 101. The rechargeable battery 101 includes battery units 1, 2, ... N. Each battery unit includes a plurality of modules. The battery unit 1 includes modules 1-1 to 1-M, the battery unit 2 includes modules 2-1 to 2-M, and the battery unit N includes modules N-1 to N-M. The plurality of modules are connected in series, in parallel, or in series and parallel. Although the number of modules included in each battery unit is the same in this example, it need not be the same.

FIG. 3 shows an example configuration of one module. The module includes a plurality of battery cells. The plurality of battery cells are connected in series, in parallel, or in series and parallel. As an example, a plurality of sets of two or more directly connected battery cells are connected in parallel.

The data acquirer 211 acquires time-series operation data from the rechargeable battery 101. The operation data may or may not be acquired at constant time intervals. The data acquirer 211 stores the acquired operation data in an operation data database (DB). The operation data may be acquired in units of cells, modules, battery units, or rechargeable batteries (pluralities of battery units connected to each other). In the following description, it is assumed that the operation data is acquired in units of rechargeable batteries.

The operation data includes information on voltage, electric power, SoC (State of Charge), and temperature. The voltage information, i.e., the voltage value corresponds to a first voltage value including charge voltage or discharge voltage. A current value may be acquired instead of the electric power value. In this case, the electric power value may be arithmetically calculated from the current value and the voltage value. In addition, the current value may be acquired instead of the SoC value to calculate the SoC by integrating the current. SoC is an index that indicates the amount of charged electricity of a battery. As an example, it is calculated by dividing the amount of electric power (amount of electric charge) accumulated in the rechargeable battery 101 by the capacity of the rechargeable battery 101.

The operation data DB 212 stores the operation data acquired by the data acquirer 211.

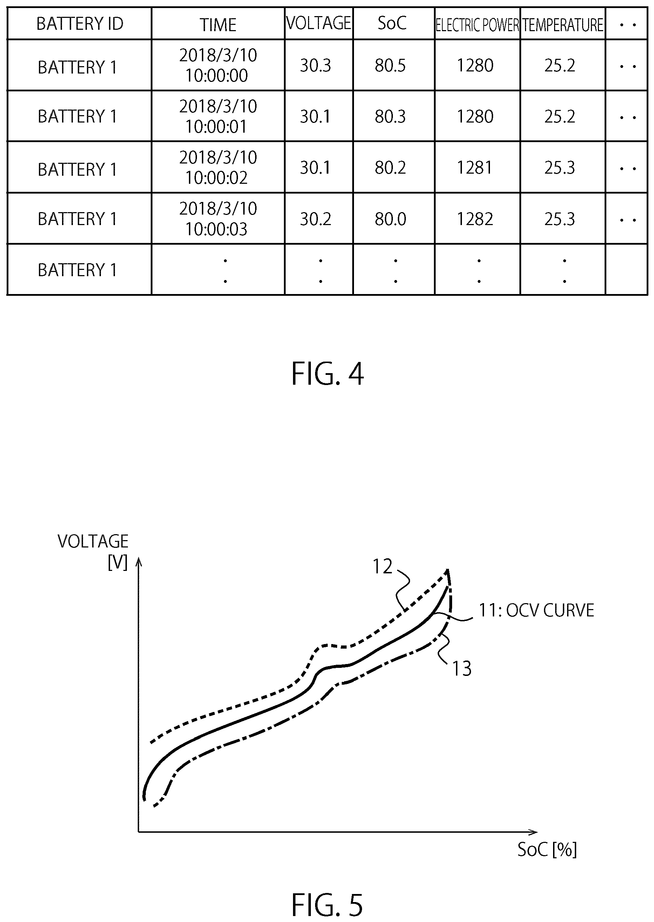

FIG. 4 shows an example of the operation data DB 212. There is shown an example of operation data acquired for the rechargeable battery 101 at intervals of one second. This operation data includes information on voltage, SoC, electric power and temperature.

The evaluation target data extractor 213 extracts operation data targeted for evaluation from the operation data DB 212. The evaluation target data extractor 213 extracts the operation data based on a pre-specified condition. For example, the pre-specified condition specifies a date, a period of time or a temperature range.

Also, the evaluation target data extractor 213 may exclude, from the extracted operation data, data with many defects or data acquired in a state other than the normal operation state (such as during a test or standby, for example).

For example, if the proportion of the number of pieces of operation data with any defects in the number of pieces of operation data included in the specified date exceeds a threshold, all the pieces of operation data of this date may be excluded. In this case, a user, or an operator, of the present apparatus may specify another date as a condition to perform extraction of operation data.

The determination on whether operation data that satisfies the specified condition is operation data acquired in a state other than the normal operation state is performed in the following manner, for example. A statistical quantity (such as an average or a standard deviation) is calculated in advance based on operation data acquired in the normal operation state. A statistical quantity is calculated for operation data that satisfies the specified condition. The calculated statistical quantity is compared with the statistical quantity calculated in advance to determine whether the difference is greater than or equal to a threshold. If the difference is greater than or equal to the threshold, it is determined that the operation data that satisfies the specified condition is data acquired in a state other than the normal operation state. Besides, a machine learning technique capable of learning a normal model such as one-class SVM (Support Vector Machine) may be used to determine whether data is acquired in a state other than the normal operation state. In addition, a variable that represents an operation state may be included in the operation data. In this case, it can be determined whether the data is acquired in the normal operation state based on the variable included in the operation data.

The OCV (Open Circuit Voltage) curve estimator (relationship information generator) 214 estimates an OCV curve in which SoC and OCV are associated with each other based on the operation data targeted for evaluation. OCV is open voltage (the voltage of an output terminal of a rechargeable battery when nothing is connected to the output terminal). The OCV curve corresponds to an example of first relationship information that represents a relationship between the OCV (a third voltage value) and the SoC (the amount of charged electricity) of the rechargeable battery 101.

FIG. 5 schematically shows an example of an OCV curve 11. The OCV curve 11 shows transition of the open voltage with respect to the SoC. A charge curve 12 schematically shows an example of transition of the charge voltage during a charge. The charge curve 12 is located above the OCV curve 11. A discharge curve 13 schematically shows an example of transition of the charge voltage during a discharge. The discharge curve 13 is located below the OCV curve 11.

The voltage included in the operation data is the voltage during a charge (charge voltage) or the voltage during a discharge (discharge voltage) and is different from the open voltage. An example method of estimating an OCV curve will be described below.

As an example, every time the SoC changes by a certain amount during a charge/discharge, the rechargeable battery 101 is temporarily stopped, and the open voltage is measured. The measured value is included in the operation data. Open voltage values and SoC values are extracted from the operation data, points of the open voltage values and SoC values are plotted, and a curve that approximates the plotted points is estimated as an OCV curve. Note that the temporarily stopping the rechargeable battery 101 for measuring the open voltage needs to be performed in the rechargeable battery 101.

The following is a method of estimating an OCV curve from operation data that does not include open voltage values. A moving average of voltage with respect to SoC is calculated based on SoC values and voltage values in operation data including charge/discharge. Specifically, (SoC value, voltage value) in the operation data are sorted in ascending order of SoC. The moving average of voltage with respect to SoC is calculated based on the sorted data. Data of the moving average of voltage values with respect to SoC is used as OCV estimation data (OCV curve). Since the charge curve transitions at a higher position than the OCV curve and the discharge curve transitions at a lower position than the OCV curve as shown in FIG. 5, the OCV curve can be approximately calculated by the moving average of voltage values including charge/discharge.

Another method is to use linear regression. The method of using linear regression uses a nature in which the OCV and the SoC have an approximately linear relationship in a certain SoC range (region). In this range, a regression function in which the charge/discharge voltage is an objective variable and the SoC is an explanatory variable is generated based on SoC values and voltage values (charge/discharge voltage) in operation data including charge/discharge. The generated regression function is used as an OCV curve. The OCV is the output value of the regression function. In a range where the SoC and the OCV can be considered as having a linear relationship, an OCV curve can be estimated by performing linear regression of the SoC and voltage value in this manner. Note that, although the regression function is a straight line and not a curve, it is referred to as an estimated OCV curve in this case as well. The regression function corresponds to an example of first relationship information that represents a relationship between the OCV (a third voltage value) and the SoC (the amount of charged electricity) of the rechargeable battery 101.

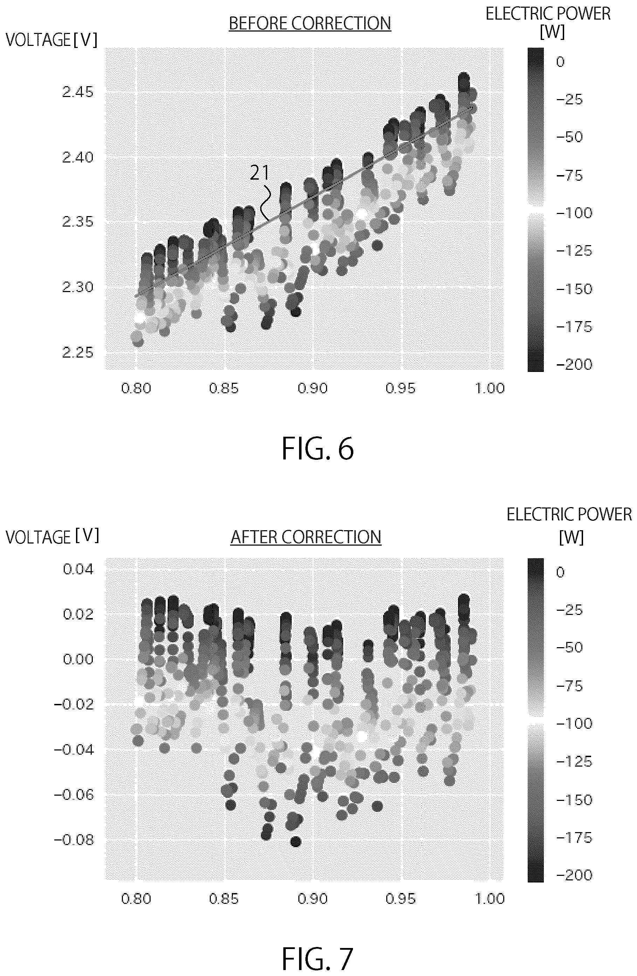

FIG. 6 shows an example in which an OCV graph is calculated by linear regression. A large number of pieces of data are plotted. Each piece of data marked with a circle in the figure corresponds to a set of an SoC value and a voltage value included in operation data. Both of data during a charge and data during a discharge are mixed. A point of an electric power value greater than 0 corresponds to data during a charge, and a point of an electric power value less than 0 corresponds to data during a discharge. A regression straight line 21 that approximates a large number of plotted points is drawn as an OCV graph.

Yet another method is to use a charge curve. Operation data obtained when a charge is performed at a constant charge rate is used. A charge curve is generated by associating voltage values (charge voltage values) and SoC values included in the operation data. The generated charge curve is regarded as an OCV curve. This method is based on the fact that the charge curve approximates a curve obtained by approximately parallel displacement of the OCV curve. The charge curve corresponds to information (second relationship information) that represents a relationship between the charge voltage and the amount of charged electricity, and the second relationship information is regarded as an OCV curve (first relationship information).

The voltage corrector 215 corrects a voltage value included in operation data according to an SoC value included in the operation data by using the estimated OCV curve and generates a corrected voltage value (second voltage value). Specifically, the corrected voltage value has a value corresponding to the difference between the voltage value and the OCV corresponding to the SoC value. As an example, the corrected voltage value can be generated by subtracting an OCV value from a voltage value included in the operation data. If the voltage value is greater than the OCV value, the voltage value obtained by the subtraction (the corrected voltage value) is greater than 0. On the other hand, if the voltage value is smaller than the OCV value, the voltage value obtained by the subtraction (the corrected voltage value) is smaller than 0. Alternatively, the corrected voltage value may be generated by subtracting the voltage value from the OCV value. In this case, if the voltage value is greater than the OCV value, the voltage value obtained by the subtraction (the corrected voltage value) is smaller than 0. On the other hand, if the voltage value is smaller than the OCV value, the voltage value obtained by the subtraction (the corrected voltage value) is greater than 0.

As will be described later, in the present embodiment, the degradation state of the rechargeable battery 101 is evaluated by focusing on dispersion (for example, the standard deviation) of corrected voltage values. As can be seen from the OCV curve shown in FIG. 5, the OCV tends to be larger as the SoC is higher, and accordingly, the measured voltage value also tends to be larger as the SoC is higher. Thus, when the SoC range of the operation data used for evaluation of the rechargeable battery 101 is narrow, the effect of change in OCV is small in the range, and thus it is possible to use voltage values in the range to calculate dispersion and evaluate the degradation state of the rechargeable battery based on the dispersion. That is, this technique uses the fact that the dispersion of voltage values increases as the degradation proceeds with respect to the OCV (see Japanese Patent No. 6313502, for example). However, when the SoC range is wide, variation in OCV due to variation in SoC effects largely, and the dispersion of voltage values cannot be appropriately evaluated. Thus, the present embodiment discloses a technique of evaluating dispersion of corrected voltage values corresponding to the difference between voltage values and OCV values. This enables excluding the effect of variation in OCV due to SoC and evaluating the degradation state by using operation data in any SoC range. In the case of performing evaluation by using dispersion of voltage values in a narrow SoC range in the above-described technique, it is necessary to acquire a sufficient number of pieces of data in the narrow SoC range. However, it takes time until a sufficient amount of data is acquired, and the evaluation cannot be appropriately performed. In contrast, in the present embodiment, since the evaluation can be performed by using data in a wide SoC range, it is only required to acquire a number of pieces of data in the wide SoC range. Therefore, in the present embodiment, it is possible to accurately perform evaluation of the degradation state even with a rechargeable battery in which only a short time has elapsed from the start of operation.

FIG. 7 shows a specific example of generating corrected voltage values. Corrected voltage values corresponding to the difference between voltage values and OCV are generated based on the OCV graph in FIG. 6, and the calculated corrected voltage values are plotted. Data of a voltage value (corrected voltage value) of 0 means that the voltage value before the correction is the same voltage as the OCV.

Note that, in the case of a technique of using a charge curve as an OCV curve, the absolute value of a corrected voltage value may have a large difference from the absolute value of the corrected voltage value in the case of using another technique described above. However, in the evaluation in the present embodiment, since it is a technique of analyzing a relative relationship, the magnitude of the absolute value has no effect.

The SoC range determiner 216 determines an SoC range (charged-electricity range) to be used for evaluation of the state (in this example, the degradation state) of the rechargeable battery 101. As an example, a predetermined SoC range may be determined. Also, a range from the minimum value to the maximum value of the SoC values included in the operation data targeted for evaluation may be determined. Also, an SoC range in which a certain number or more of pieces of data are included may be determined. Also, a plurality of SoC ranges may be selected. It is also effective to determine the SoC range in the following method.

An example is a method of determining the SoC range based on estimation errors of the OCV curve estimated by the OCV curve estimator 214. Specifically, the SoC range is determined based on the difference between the voltage values in the operation data and the OCV. For example, for each SoC, the maximum value of the voltage values in the operation data is found, and it is determined whether the difference between the found maximum value and the estimated OCV value is greater than or equal to a threshold. If the difference is greater than or equal to the threshold, it is determined that the estimation error of the OCV is large. If the difference is less than the threshold, it is determined that the estimation error of the OCV is small. Another statistical quantity such as an average value or the minimum value may also be used instead of the maximum value. The OCV curve estimator 214 selects, as the SoC range, a set of SoC values with small estimation errors.

As a specific example, for SoC values of 0.50 to 1.00, it is determined whether the estimation error is large for each of 0.50, 0.51, 0.52, ..., 0.99 and 1.00. It is assumed that it is determined that the estimation error is small for 0.60 to 0.80 and 0.85 to 0.90 and the estimation error is large for 0.5 to 0.59, 0.81 to 0.84 and 0.91 to 1.00. In this case, 0.60 to 0.80 and 0.85 to 0.90 are selected as the SoC range.

Another example is a method of determining the SoC range based on distribution of electric power values or temperature for SoC. A plurality of SoC sections with certain widths are set as candidates of the SoC range. Distribution of electric power values or temperature is calculated for each section. The SoC range is selected based on the distribution of each section. SoC sections with a large inter-distribution distance are excluded, and a set of the remaining SoC sections is used as the SoC range. For example, an average of inter-distribution distances is calculated, and SoC sections for which the difference between its inter-distribution distance and the average is greater than or equal to a threshold are excluded. The inter-distribution distance includes an index such as the KL distance (KL: Kullback-Leibler), the L2 distance or the Pearson distance. A statistical quantity such as an average or variance of distribution may also be used instead of an index.

The state (in this example, the degradation state) of the rechargeable battery 101 is evaluated by the state evaluator 217 by using corrected voltage values based on data belonging to the SoC range. In the present embodiment, an evaluation function in which a corrected voltage value is an input variable (explanatory variable) and the degradation state of the rechargeable battery 101 is an output variable (objective variable) is used. The degradation state is evaluated by using a phenomenon in which dispersion of voltage values acquired during operation increases in a battery with a high degree of degradation. In the present embodiment, the degradation state is evaluated by using dispersion of corrected voltage values, which are relative values with respect to OCV, as described above, instead of directly using the voltage values.

The evaluation function DB 219 stores data of evaluation functions. The evaluation functions are stored for respective battery hierarchies such as battery cell, module, battery unit and the entire battery. The state evaluator 217 reads, from the evaluation function DB 219, an evaluation function for the same hierarchy as the battery hierarchy for which data used for the current evaluation is acquired. If a particular hierarchy is determined as the hierarchy targeted for evaluation, only an evaluation function for the particular hierarchy may be stored in the evaluation function DB 219.

A numerical representation of the dispersion of corrected voltage values is defined as a feature FV. As an example of the feature FV, a standard deviation or variance of the corrected voltages can be used. Alternatively, if data of a charge and a discharge is included, the difference between an average of corrected voltage during a charge and an average of corrected voltage during a discharge, the difference between a median value of corrected voltage during a charge and a median value of corrected voltage during a discharge or the like can also be used as the feature FV. Using the feature FV, the evaluation function for the degradation state of the rechargeable battery can be represented in the following equation. SoH (State of Health) is an index that represents the degradation state of the rechargeable battery. As an example of SoH, a ratio of the capacity of the rechargeable battery and its rated capacity can be used. The letters "a" and "b" are coefficients and are calculated in advance by learning.

$$SoH = a * FV + b \quad (1)$$

Equation (1) is a linear equation, but may be of any type as long as it is a technique of constructing a regression model, such as non-linear regression, machine learning (such as a neural network, random forests or SVR (Support Vector Regression)). A model by a linear equation, a non-linear equation or machine learning may include a statistical quantity of at least one of temperature and electric power values as an input variable. A plurality of models may be combined. Also, classification by the temperature or electric power value (the charge rate or discharge rate may also be used) may be performed to generate an evaluation function for each class.

If an evaluation function corresponding to the battery hierarchy targeted for evaluation is not stored in the evaluation function DB 219, the evaluation target data extractor 213 may correct voltage values, electric power values and the like included in the operation data. For example, it is assumed that the evaluation function is a function for the hierarchy of battery cell, and the battery hierarchy targeted for the current evaluation is module. In this case, the correction of electric power values is performed by dividing the electric power values by the number of cells included in the module. The correction of voltage values is performed by dividing the voltage values by the number of series connections of cells (the number of cells connected in series).

An evaluation result (SoH) that represents the degradation state calculated by the state evaluator 217 is output by the evaluation result output device 218. As an example, the evaluation result output device 218 is a display that displays data, such as a liquid crystal display, an organic EL display or a plasma display. Alternatively, the evaluation result output device 218 may be a communication device that sends data to another communication device in a wired or wireless manner or a printer that prints data.

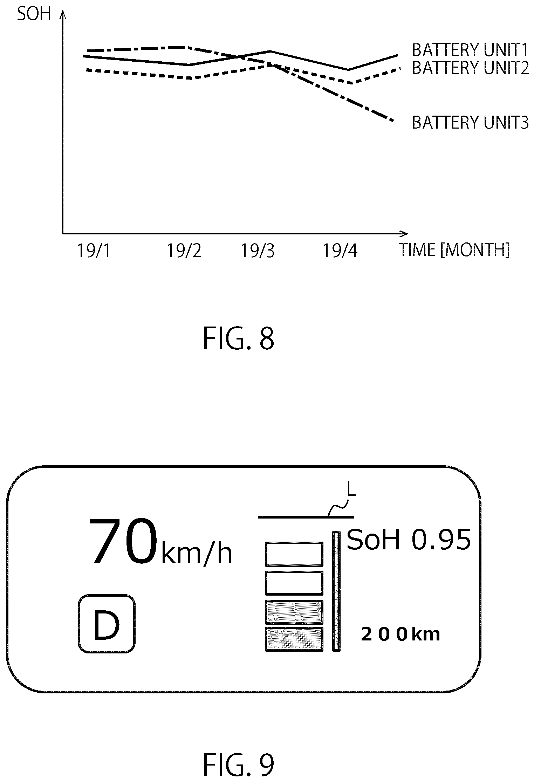

FIG. 8 shows an example of output of an evaluation result. There is shown an example of graphical representation of transition of SOH calculated by evaluating the degradation state of battery units 1 to 3 every month. In this example, the horizontal axis indicates the month. However, the horizontal axis may indicate the date, the cumulative value of the amount of usage of the battery (Ah or Wh) or another unit such as a value that standardizes them (equivalent cycle count). Also, if the present apparatus is provided with a moving vehicle, the horizontal axis may indicate the total travel distance. Also, although transition of the SoH of a plurality of different battery units is displayed at the same time in this example, only transition of the SoH of a single battery unit may be displayed.

A point that indicates an evaluation result may be selected by the user, or the operator, of the present apparatus. A GUI (Graphical User Interface) such as a keyboard, a mouse or a touch panel can be used for the selection. When the point of a certain evaluation result is selected by the user via the GUI, the evaluation result output device 218 may display operation data used for calculation of the selected evaluation result or information based on the operation data.

A displayed variable includes a voltage, current, electric power value, SoC, SoH, temperature or the like.

As a form of display, a table that includes statistical quantities such as an average, variance, minimum value and maximum value may be displayed. Alternatively, a trend graph that shows time-series transition such as with time on the horizontal axis and voltage on the vertical axis may be displayed. Alternatively, a graph (QV plot) with SoC on the horizontal axis and voltage on the vertical axis may be displayed. The form of display and displayed variable may be switched by the user via the GUI.

The present apparatus may be provided to a moving vehicle such as an EV (Electric Vehicle), and the display device may be disposed to the dashboard of the driver's seat. The current SoH may be displayed on the display device.

FIG. 9 is an example of displaying an indication on the display device of the EV that the current speed is 70 km/h, the distance to empty is 200 km and the SoH of the rechargeable battery 101 is 0.95 during travel in a driving mode. A horizontal line L indicates an SoH of 1.0.

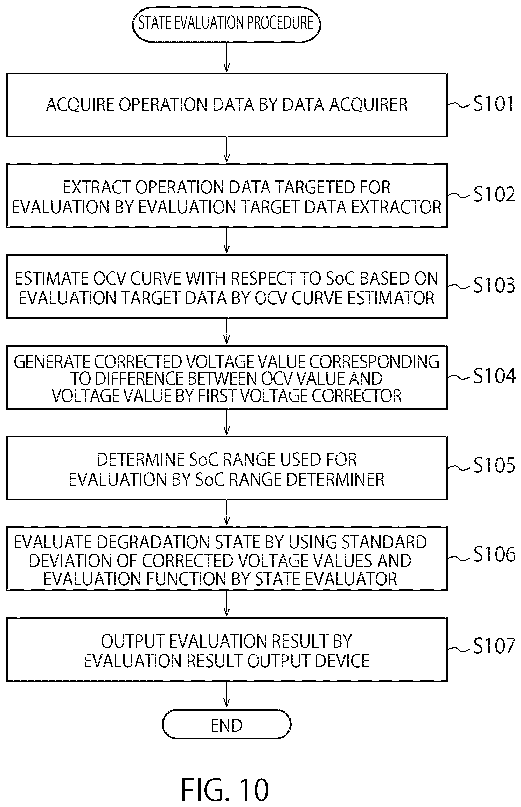

FIG. 10 is a flow chart of an example of operations of the rechargeable battery evaluation apparatus 201 according to the first embodiment.

The data acquirer 211 acquires operation data from the rechargeable battery 101 and stores the acquired operation data in the operation data DB 212 (S101).

The evaluation target data extractor 213 extracts operation data targeted for evaluation from the operation data DB 212 (S102).

The OCV curve estimator 214 estimates an OCV curve with respect to SoC based on the operation data targeted for evaluation (S103).

The voltage corrector 215 generates a corrected voltage value according to the difference between an OCV value corresponding to an SOC value and a voltage value for each piece of operation data based on the OCV curve (S104).

The SoC range determiner 216 determines an SoC range used for evaluation of the degradation state based on at least the former of the operation data and the OCV curve (S105).

The state evaluator 217 evaluates the degradation state of the rechargeable battery 101 by using the standard deviation of the first voltage and the evaluation function in the evaluation function DB 219 (S106).

The evaluation result output device 218 outputs an evaluation result (S107).

As above, according to the first embodiment, it is possible to evaluate the degradation state of the rechargeable battery 101 by using operation data in a wide SoC range, and thus accurately evaluate the degradation state of the rechargeable battery 101 at an early stage from the start of operation of the rechargeable battery 101.

(Variation)

In the first embodiment, a value corresponding to the difference between a voltage value and an OCV value is used as a corrected voltage value, and a standard deviation of corrected voltage values is used as a feature. In the present variation, the difference between a charge voltage and a discharge voltage at the same SoC value is calculated based on operation data acquired when charge/discharge is performed in a charge/-discharge pattern including both of charge and discharge, and the calculated difference is used as a corrected voltage value. A value based on corrected voltage values (for example, an average value, minimum value, maximum value or median value of the corrected voltage values) is used as a feature. The process of calculating the difference between the charge voltage and the discharge voltage at the same SoC value corresponds the process of calculating a corrected voltage value obtained by correcting the charge voltage or discharge voltage according to the SoC value.

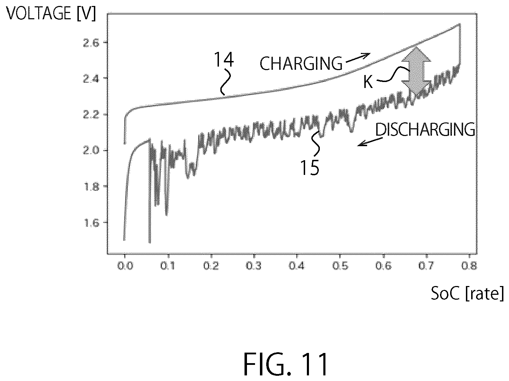

FIG. 11 is an illustrative diagram of the present variation. It is assumed that charge/discharge is performed in a charge/discharge pattern in which the charge is started from when the SoC is near 0, the discharge is started when the SoC reaches near 0.8 during the charge, and the discharge is stopped when the SoC is near 0. A graph 14 represents transition of the charge voltage in this process, and a graph 15 represents transition of the discharge voltage. The horizontal axis indicates the SoC, and the vertical axis indicates the voltage. Operation data obtained when charge/discharge of the rechargeable battery 101 is performed in this charge/-discharge pattern is acquired by the data acquirer 211.

The state evaluator 217 calculates the difference between the charge voltage and discharge voltage at the same SoC (reference character K in FIG. 11), and the calculated difference is used as a corrected voltage value. In the present variation, the process of the OCV curve estimator 214 is unnecessary. The state evaluator 217 calculates a feature based on the calculated corrected voltage value and estimates the SoH in a manner similar to the first embodiment.

The SoC range determiner 216 may determine an SoC range used for evaluation in a manner similar to the first embodiment. For example, when the difference between the charge voltage and discharge voltage at a certain SoC value is greater than or equal to a threshold, it may be determined that the rechargeable battery 101 is not in the normal operation state, and the SoC may not be included in the SoC range used for evaluation.

According to the present variation, it is unnecessary to calculate the OCV curve, and it is possible to reduce the processing load as compared to the first embodiment. Also, implementation is possible with a simpler configuration than in the first embodiment.

(Second Embodiment)

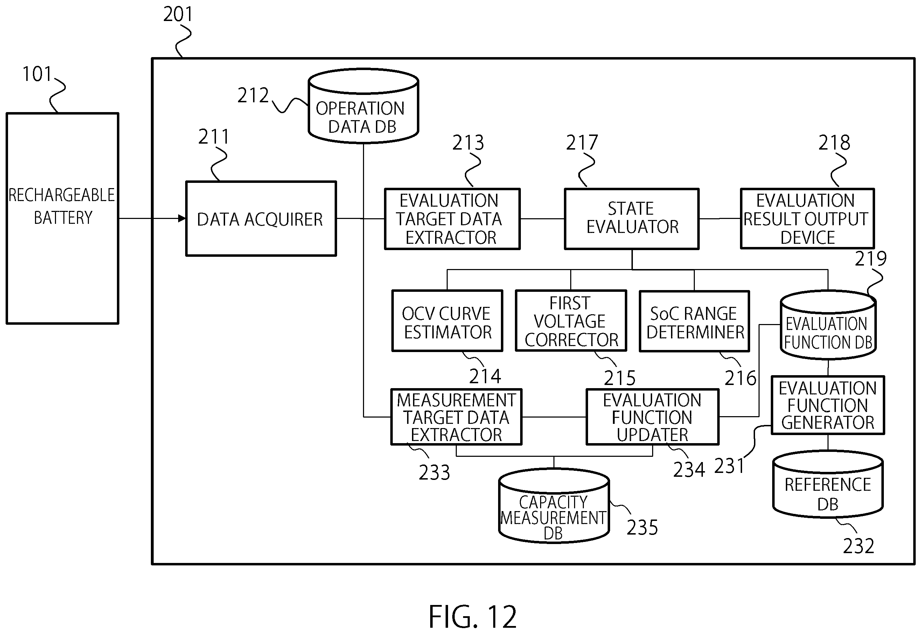

FIG. 12 is a block diagram of a rechargeable battery evaluation apparatus 201 according to a second embodiment. An evaluation function generator 231, a reference DB 232, a measurement target data extractor 233, an evaluation function updater 234 and a capacity measurement DB 235 are added to the rechargeable battery evaluation apparatus 201 of the first embodiment (FIG. 1). The same elements as in FIG. 1 are given the same reference characters, and their descriptions will be omitted as appropriate except for extended or modified processes.

The reference DB 232 stores training data used for training the evaluation function.

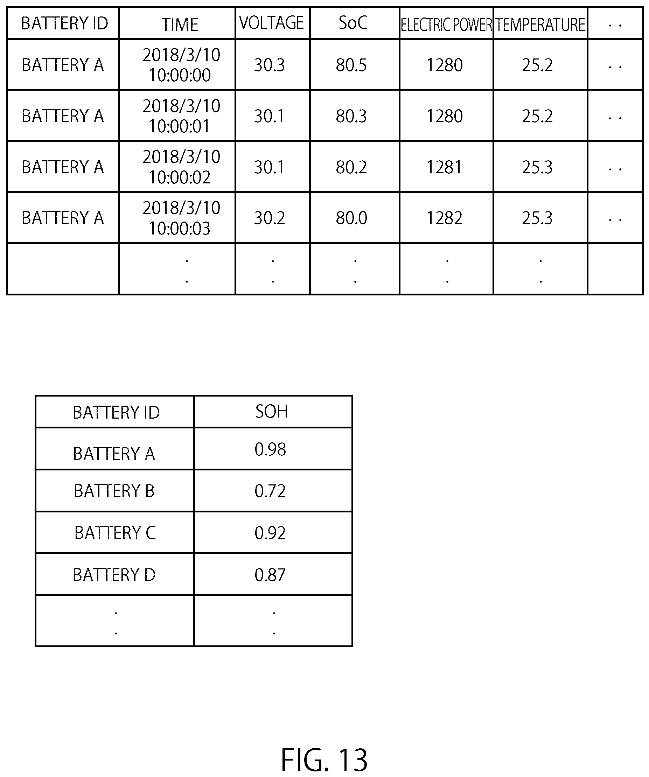

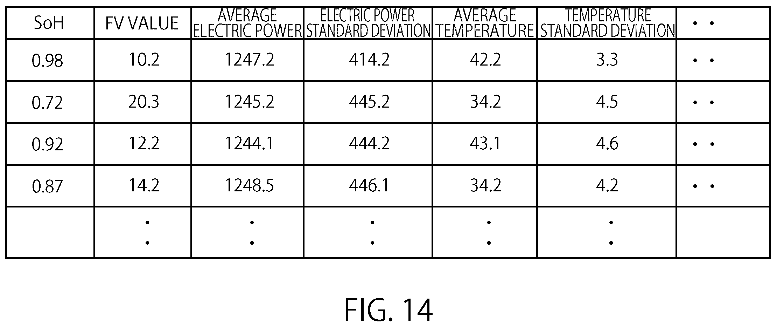

FIGS. 13 and 14 show examples of training data stored in the reference DB 232. The training data in FIG. 13 includes operation data (such as battery ID, time, voltage, SoC, electric power and temperature) acquired from the rechargeable battery 101 and SoH corresponding to each battery ID. The SoH is measured in advance and stored in the reference DB 232. For example, the internal resistance of the rechargeable battery 101 may be measured to calculate the SoH based on the amount of change in the internal resistance from its initial value. The SoH may also be calculated based on the amount of charged electricity required to put the rechargeable battery 101 from a predetermined electricity storage state (e.g., a fully-discharged state) to a fully-charged state. The SoH may be calculated by another method. Here, IDs of battery cells are used as the battery IDs.

The training data in FIG. 14 is data generated from the training data in FIG. 13, and includes SoH, FV value, average electric power, electric power standard deviation, average temperature, temperature standard deviation and the like. The method of calculating the FV value (in this example, a standard deviation) is similar to that in the first embodiment. The calculation of the FV value may be performed by using the state evaluator 217, the OCV curve estimator 214, the voltage corrector 215 and the SoC range determiner 216, in a manner similar to the first embodiment. Alternatively, the FV value may be calculated in a procedure similar to that in the first embodiment in an apparatus different from the present apparatus.

The training data of the form in FIG. 13 may not be stored in the reference DB 232. In this case, the training data of the form in FIG. 14 is generated from the training data of the form in FIG. 13 by an external apparatus and is stored in the reference DB 232.

The evaluation function generator 231 generates an evaluation function based on the training data of the form in FIG. 14 in the reference DB 232. The evaluation function generator 231 generates an SoH estimation model in which the SoH is an objective variable and some or all items including the feature (FV) are explanatory variables. The estimation technique may be of any type as long as it is a technique of constructing a regression model, such as linear regression, non-linear regression, machine learning (such as a neural network, random forests or SVR (Support Vector Regression)). A plurality of models may be combined, or a statistical quantity of at least one of temperature and electric power values may be included as an input variable. Also, classification by the temperature or electric power value (the charge rate or discharge rate may also be used) may be performed for construction for each class. Equation (1) mentioned above is an example of generating the SoH estimation model by linear regression. The generated estimation model corresponds to the evaluation function.

The measurement target data extractor 233 extracts data targeted for capacity measurement based on the operation data DB 212. The data targeted for capacity measurement is data in which the measured voltage monotonously increases from a lower-limit voltage indicating the fully-discharged state to an upper-limit voltage indicating the fully-charged state. The voltage values may be smoothed in advance. A period in which the upper-limit voltage is reached from the lower-limit voltage is referred to as a capacity measurement period.

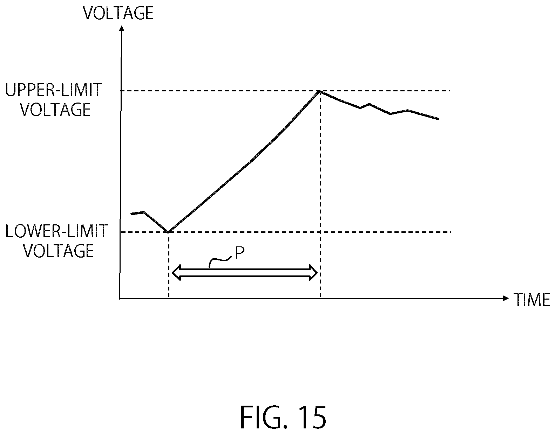

FIG. 15 shows an example of data in which the measured voltage monotonously increases from the lower-limit voltage indicating the fully-discharged state to the upper-limit voltage indicating the fully-charged state. A period P is the capacity measurement period.

The measurement target data extractor 233 integrates current values in the capacity measurement period to measure the amount of electric charge (AH) charged during the period. The measured amount of electric charge is divided by the rated value of the battery to measure the SoH.

The measurement target data extractor 233 stores the battery ID, the time, the measured SoH and the charge rate in the capacity measurement DB 235. The measurement target data extractor 233 may calculate various statistical quantities based on the extracted data and further store the calculated statistical quantities in the capacity measurement DB 235.

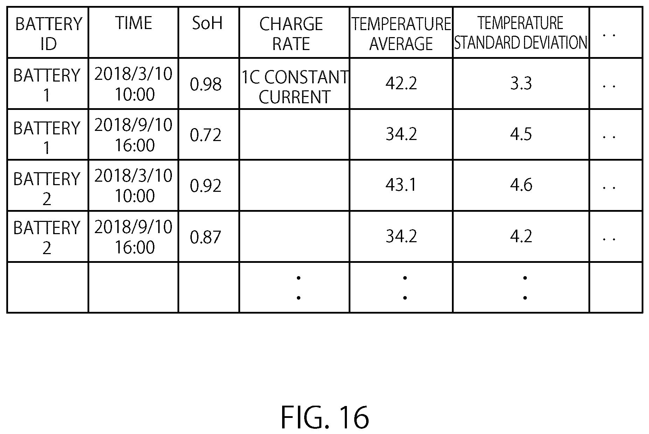

FIG. 16 shows an example of the capacity measurement DB 235. The time is the time at which the SoH is measured. However, another time such as the starting or ending time of the extracted data may also be used. The charge rate is calculated by analyzing the current and electric power values in the data in the capacity measurement period to determine by which of constant current charge and constant power charge the charge is performed. As statistical quantities, statistical quantities (an average and a standard deviation) of temperature are stored.

The evaluation function updater 234 determines whether it is necessary to update the evaluation function in the evaluation function DB 219 based on the capacity measurement DB 235, and when determining that update is necessary, updates the evaluation function.

As an example, the difference between an SoH estimated by the state evaluator 217 based on the same data as in the capacity measurement period and an SoH measured from the data in the capacity measurement period is calculated.

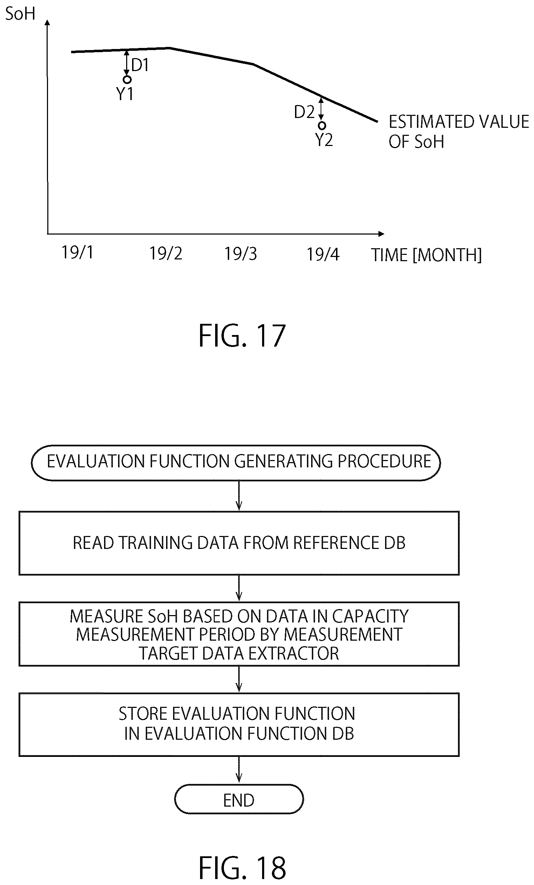

FIG. 17 shows an example of difference absolute values D1 and D2 between SoHs estimated by the state evaluator 217 and SoHs measured from the data in the capacity measurement period. The solid-line graph indicates transition of the SoH estimated by the state evaluator 217. Point Y1 and point Y2 indicate SoHs measured from the data in the capacity measurement period.

The evaluation function updater 234 updates the evaluation function when the difference is greater than or equal to a threshold. For example, a coefficient is added to the evaluation function such that the estimated SoH is equal to the measured SoH. In the example of FIG. 17, when the difference absolute value D1, which is greater than the threshold, is calculated, a coefficient (constant) to subtract from the D1 is added to the evaluation function. Alternatively, the evaluation function may be multiplied by a coefficient corresponding to D1. Alternatively, a coefficient (constant) to subtract or add an average value (or the maximum value, minimum value or the like) of a plurality of difference absolute values may be added to the evaluation function. For example, a constant to subtract an average value (or the maximum value, minimum value or the like) of D1 and D2 is added to the evaluation function. Alternatively, the evaluation function may be multiplied by a coefficient corresponding to the average value.

The evaluation function may also be updated by a method other than adding or multiplying a coefficient (constant). For example, a linear regression equation is calculated by performing linear regression of measured values of SoH from estimated values of SoH. The output value of the evaluation function is used an explanatory variable of the linear regression equation. The linear regression equation in which the output value of the evaluation function is assigned to the explanatory variable is used as an updated evaluation function. The output of the linear regression equation is the estimated SoH.

Also, the evaluation function may be recreated by using the FV value and the SOH in the capacity measurement DB 235 at the same time.

The above-described methods of updating the evaluation function may be switched according to the number of samples. For example, when the number of samples is less than a threshold, the evaluation function is updated by adding or multiplying a coefficient. When the number of samples is greater than or equal to a threshold, the method of performing linear regression of measured values of SoH from estimated values of SoH is used. Alternatively, the evaluation function may be recreated by using the FV value calculated by the state evaluator 217 and the SoH in the capacity measurement DB 235.

FIG. 18 is a flow chart showing an example of processes of the evaluation function generator 231. The evaluation function generator 231 reads training data from the reference DB 232 (S201). An evaluation function is generated based on the read training data (S202). The generated evaluation function is stored in the evaluation function DB 219 (S203).

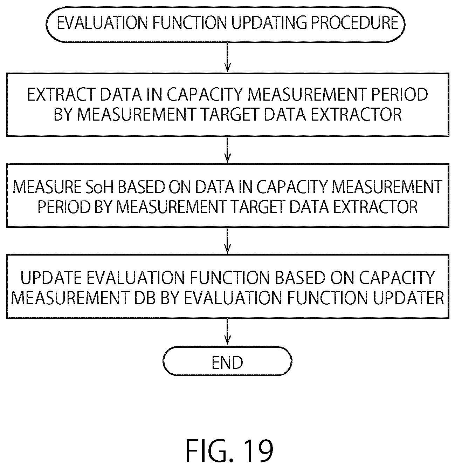

FIG. 19 is a flow chart of an example of processes of the measurement target data extractor 233 and the evaluation function updater 234. The measurement target data extractor 233 extracts data in the capacity measurement period from the operation data DB (S301). The measurement target data extractor 233 measures the SoH based on the extracted data (S302). The battery ID, time, measured SoH and charge rate are stored in the capacity measurement DB 235 (also S302). The measurement target data extractor 233 may calculate various statistical quantities based on the extracted data and further store the calculated statistical quantities in the capacity measurement DB 235. The evaluation function updater 234 updates the evaluation function in the evaluation function DB 219 based on the capacity measurement DB 235 (S303).

By generating and updating the evaluation function in the above-described manner, it is possible to perform more accurate evaluation while reducing the number of pieces of data required for evaluation of the degradation state.

(Third Embodiment)

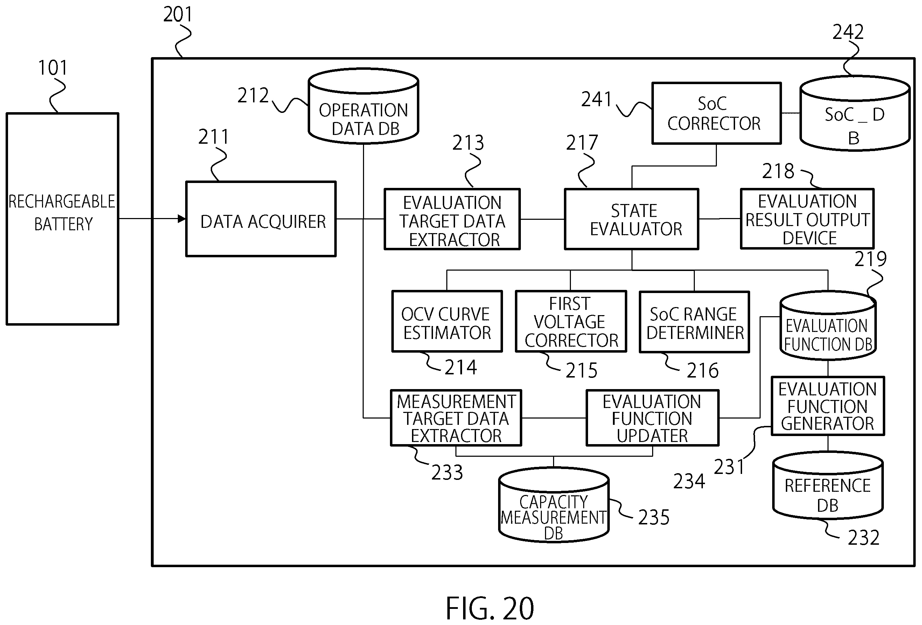

FIG. 20 is a block diagram of a rechargeable battery evaluation system according to a third embodiment. An SoC corrector 241 and an SoC_DB 242 are added.

The SoC corrector 241 corrects an SoC value included in operation data. Since the SoC value is calculated based on the current, if there are errors in current measurement, errors also accumulate in the SoC value. If the rechargeable battery 101 is operated for a long time, the errors in the SoC value may increase. The SoC corrector 241 performs correction to reduce the errors in the SoC value.

As a correction method, an electricity storage state (the amount of electric power) at the start of a previous charge, an electricity storage state (the amount of electric power) at the end of the charge, and an SoC value at the end of the charge are associated with the charge rate and saved in the SoC_DB 242. Similarly, an electricity storage state (the amount of electric power) at the start of a previous discharge, an electricity storage state (the amount of electric power) at the end of the discharge, and an SoC value at the end of the discharge are associated with the charge rate and saved in the SoC_DB 242. The electricity storage state at the start of the charge or the electricity storage state at the start of the discharge corresponds to a reference electricity storage state. The information saved in the SoC_DB 242 corresponds to reference data including the reference electricity storage state and the amount of charged electricity in the reference electricity storage state (a first amount of charged electricity).

It is assumed that the operation data (or part of the operation data) extracted by the evaluation target data extractor 213 is operation data acquired when the rechargeable battery 101 is charged from a first electricity storage state to a second electricity storage state at a first charge rate. The SoC value in the second electricity storage state is compared with the SoC value when a previous charge is performed from the first electricity storage state to the second electricity storage state at the same first charge rate. When the difference between the SoC values is greater than or equal to a threshold, the SoC value in the operation data is corrected based on the difference between the SoC values. For example, the difference between the SoC values is divided by the number of pieces of data in the operation data, and the value obtained by the division is added to the SoC value in the operation data. Correction of the SoC value can be performed similarly in the case of a discharge from the second electricity storage state to the first electricity storage state. This can suppress accumulation of errors in calculating the SoC value. The OCV curve estimator 214, the voltage corrector 215, the SoC range determiner 216 and the state evaluator 217 perform processes based on the corrected SoC value. As an example, the first electricity storage state and the second electricity storage state correspond to the electricity storage state at the start of the charge or the electricity storage state at the start of the discharge.

Note that the SoC corrector 241 may not perform correction if a previous charge or discharge has not been performed in the same conditions.

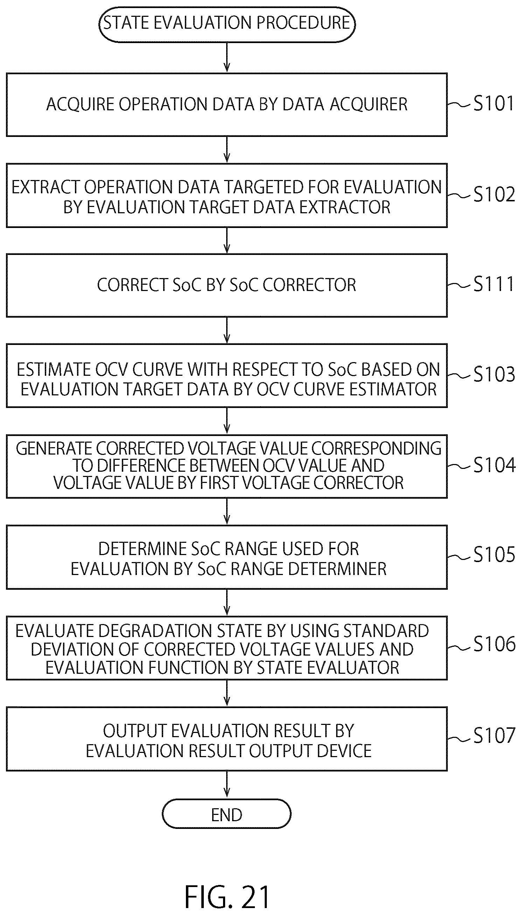

FIG. 21 is a flow chart of an example of operations of the rechargeable battery evaluation apparatus 201 according to the third embodiment. Step S111 is added between steps S102 and S103 in the flow chart in the first embodiment. In step S111, the SoC corrector 241 performs correction of an SoC value included in operation data. Other steps are similar to those in the first embodiment.

As above, according to the third embodiment, it is possible to reduce errors in the calculated SoC value, and thus more accurately evaluate the degradation state.

(Fourth Embodiment)

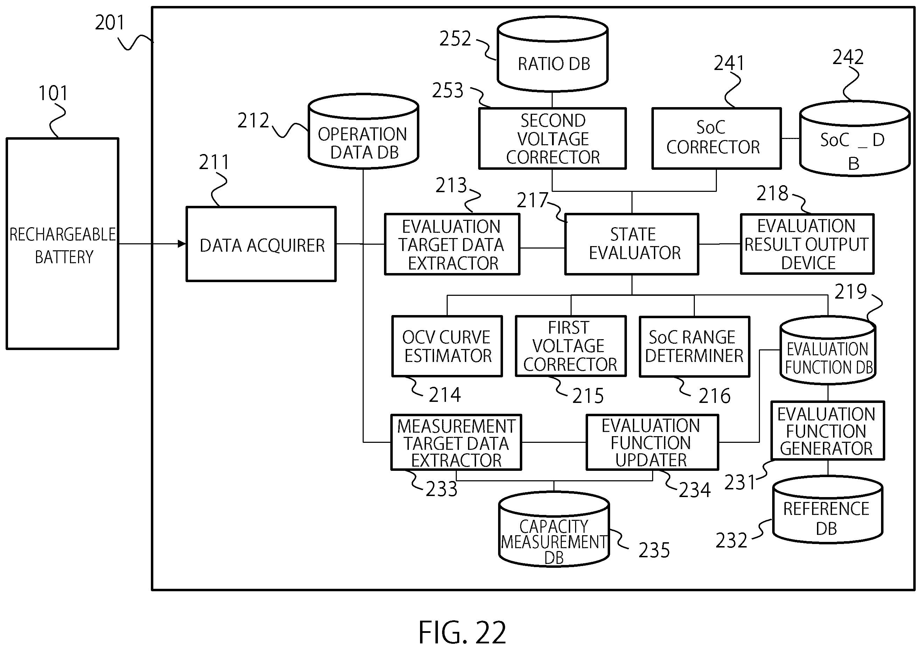

FIG. 22 is a block diagram of a rechargeable battery evaluation system according to a fourth embodiment. A voltage corrector 253 (second voltage corrector) and a ratio DB 252 are added to the rechargeable battery evaluation apparatus 201 in the third embodiment. The voltage corrector 253 and the ratio DB 252 may be added to the rechargeable battery evaluation apparatus 201 in the first embodiment or second embodiment.

The magnitude of internal resistance of a rechargeable battery (the rechargeable battery 101 or another rechargeable battery of the same type) corresponding to the SoC is measured in advance. A particular SoC is defined as a reference SoC. The ratio of the internal resistance at an SoC at least other than the reference SoC with respect to the internal resistance at the reference SoC is stored in the ratio DB 252. For example, it is assumed that the internal resistance at an SoC of 80% is measured as 1.1 times with respect to the internal resistance at an SoC 50%. This ratio is stored in the ratio DB 252. The information stored in the ratio DB 252 corresponds to ratio data in which a plurality of SoCs (amounts of charged electricity) and a plurality of ratios are associated with each other.

The voltage corrector 253 corrects a voltage value included in operation data according to an SoC value included in the operation data. The voltage corrector 253 corrects the voltage value included in the operation data by dividing it by a ratio with respect to the SoC value included in the operation data. In the case of the above example, the voltage value included in operation data with an SoC value of 80% is divided by 1.1 to correct the voltage value. When the SoC value is the reference SoC, the ratio is 1.0 and thus the voltage value does not change by the correction. When the SoC value is the reference SoC, the correction of the voltage value may not be performed. The voltage corrector 215 performs processing on the voltage value after being corrected by the voltage corrector 253. Alternatively, it is also possible that the voltage corrector 253 performs correction on the voltage value after being corrected by the voltage corrector 215.

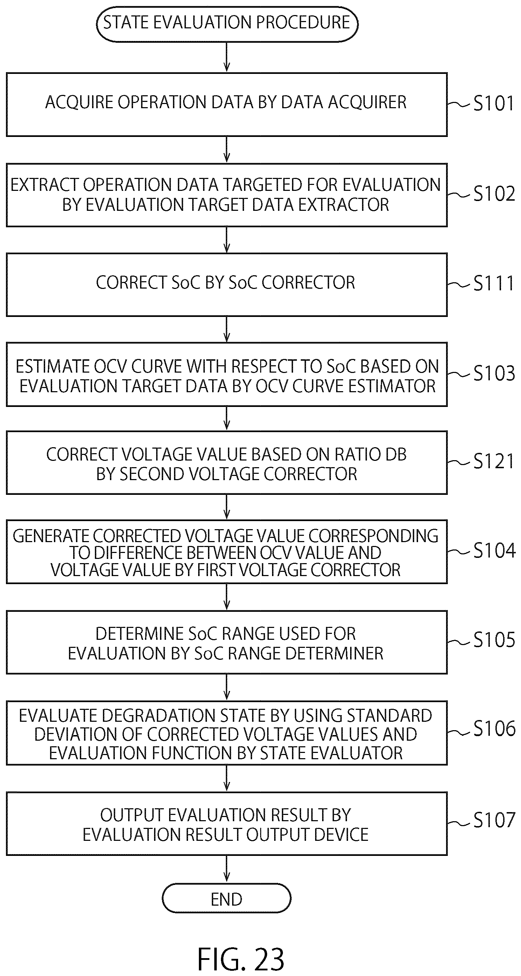

FIG. 23 is a flow chart of an example of operations of the rechargeable battery evaluation apparatus 201 according to the fourth embodiment. Step S121 is added between steps S103 and S104 in the flow chart in the third embodiment. In step S121, the second voltage corrector 253 corrects the voltage value included in the operation data based on the ratio DB 252 and the SoC value included in the operation data. Other steps are similar to those in the first embodiment.

As above, according to the fourth embodiment, it is possible to reduce errors in the calculated SoC value, and thus more accurately evaluate the degradation state.

According to the present embodiment, it is possible to accurately evaluate the degradation state by correcting the voltage value by taking into consideration variation in the internal resistance due to difference in the SoC.

(Fifth Embodiment)

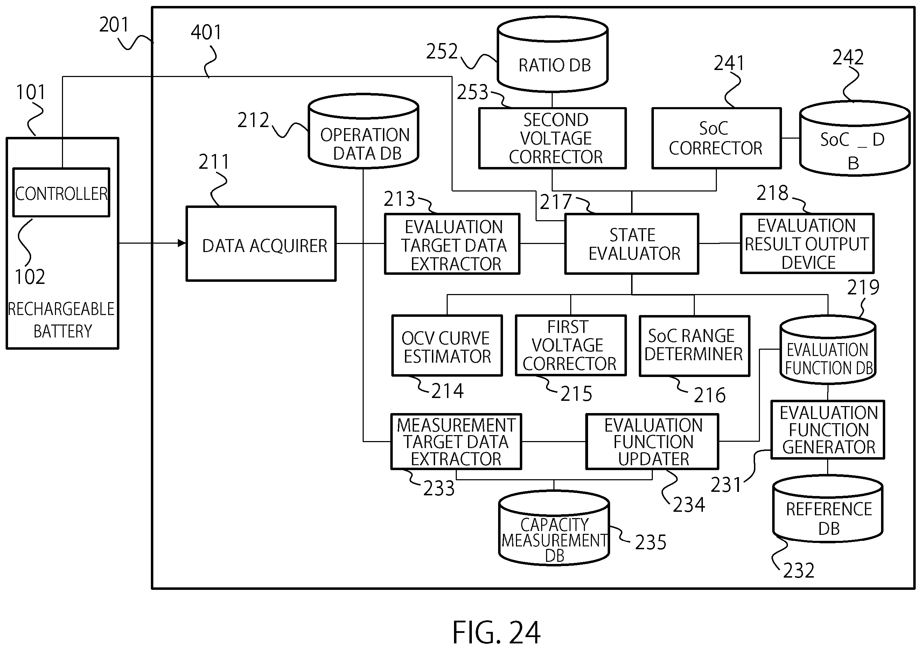

FIG. 24 is a block diagram of a rechargeable battery evaluation system according to a fifth embodiment. Although the present embodiment shows an example of extending the rechargeable battery evaluation system in the fourth embodiment, similar extension can be applied to the rechargeable battery evaluation system in the first to third embodiments.

The rechargeable battery 101 includes a controller 102. A connection line 401 is provided for feedback of information from the state evaluator 217 to the controller 102 of the rechargeable battery 101.

The state evaluator 217 provides the SoC value (current SoC value) in the latest operation data accumulated in the operation data DB 212 and information on the SoC range selected by the SoC range determiner 216 to the controller 102 of the rechargeable battery 101.

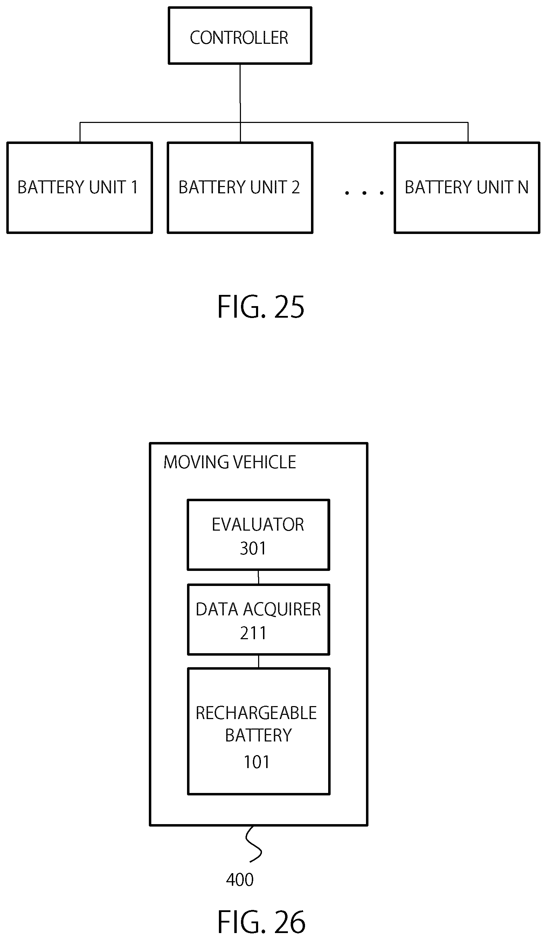

FIG. 25 shows an example internal configuration of the rechargeable battery 101. The controller 102 and a plurality of battery units 1 to N are provided. The controller 102 controls the plurality of battery units 1 to N. The controller 102 determines a charge/discharge command assigned to each battery unit such that operation data is acquired within the SoC range notified from the state evaluator 217, and provides the charge/discharge command to each battery unit. Each battery unit performs charge/discharge according to the charge/discharge command. If the rechargeable battery evaluation system is provided with a moving vehicle, the regenerative ratio when the moving vehicle performs braking may be controlled such that operation data at an SoC included in the SoC range is acquired.

As above, according to the fifth embodiment, the state evaluator 217 feeds back information based on operation data to the controller 102 of the rechargeable battery 101, so that a lot of data effective for evaluation of the degradation state can be acquired. Therefore, it is possible to enhance the accuracy of evaluation of the degradation state.

(Sixth Embodiment)

The present embodiment shows an example configuration in which the rechargeable battery evaluation system is provided with a moving vehicle or an example configuration in which the rechargeable battery evaluation system is distributed over a system including a moving vehicle and a server. However, the moving vehicle is an example, and it is also possible to use any other apparatus with computer resources instead of the moving vehicle.

(First Example)

FIG. 26 shows an example in which the rechargeable battery evaluation system in FIG. 1 according to the first embodiment is provided with a moving vehicle 400. The moving vehicle 400 includes the rechargeable battery 101, the data acquirer 211, and an evaluator 301. The evaluator 301 includes elements other than the data acquirer 211 in the rechargeable battery evaluation apparatus in FIG. 1 (the operation data DB 212, the evaluation target data extractor 213, the state evaluator 217, the OCV curve estimator 214, the voltage corrector 215, the SoC range determiner 216, the evaluation result output device 218 and the evaluation function DB 219). The evaluator 301 may further include the SoC corrector 241 and the SoC_DB 242 in FIG. 20. Also, the evaluator 301 may further include the voltage corrector 253 and the ratio DB 252 in FIG. 22. The configuration in FIG. 26 enables constant (real-time) evaluation of the rechargeable battery 101 provided with the moving vehicle 400 during operation.

(Second Example)

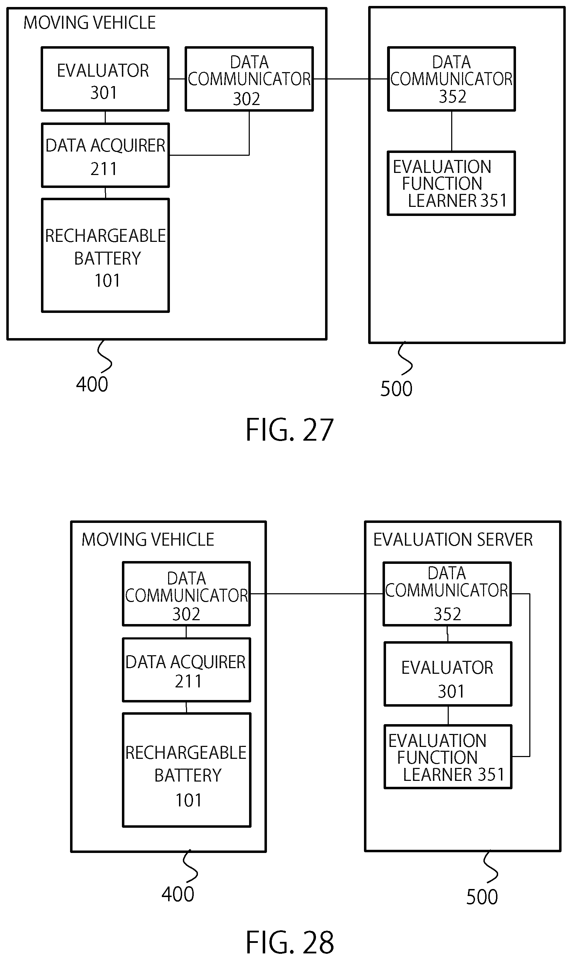

FIG. 27 shows an example in which the rechargeable battery evaluation system in FIG. 12, 20 or 22 is distributed over the moving vehicle 400 and an evaluation server 500. The same elements as in FIG. 26 are given the same reference characters, and their descriptions will be omitted as appropriate. The moving vehicle 400 includes the rechargeable battery 101, the data acquirer 211, the evaluator 301 and a data communicator 302 (first data communicator). The evaluation server 500 includes an evaluation function learner 351 and a data communicator 352 (second data communicator). The rechargeable battery 101, the data acquirer 211 and the evaluator 301 of the moving vehicle 400 are the same as in FIG. 26.

The data communicator 302 of the moving vehicle 400 performs wired or wireless communication with the data communicator 352 of the evaluation server 500. The evaluation function learner 351 of the evaluation server 500 includes the measurement target data extractor 233, the capacity measurement DB 235, the evaluation function updater 234, the evaluation function generator 231 and the reference DB 232 in FIG. 12. Elements that require a lot of computing resources are provided to the evaluation server 500.

The data communicator 302 of the moving vehicle 400 sends the operation data acquired by the data acquirer 211. The data communicator 352 of the evaluation server 500 receives the operation data from the moving vehicle 400 and sends data of the evaluation function generated or updated by the evaluation function learner 351 to the data communicator 302 of the moving vehicle 400. The configuration in FIG. 27 enables constant (real-time) evaluation of the rechargeable battery 101 provided with the moving vehicle 400 during operation.

(Third Example)

FIG. 28 shows another example in which the rechargeable battery evaluation system in FIG. 12, 20 or 22 is distributed over the moving vehicle 400 and the evaluation server 500. The moving vehicle 400 includes the rechargeable battery 101, the data acquirer 211 and the data communicator 302 (first data communicator). The evaluation server 500 includes the data communicator 352 (second data communicator), the evaluator 301 and the evaluation function learner 351. Unlike the configuration in FIG. 27, the evaluator 301 is provided to the evaluation server 500 instead of the moving vehicle 400. The same elements as in FIG. 27 are given the same reference characters, and their descriptions will be omitted as appropriate.

The data communicator 302 of the moving vehicle 400 sends the operation data acquired by the data acquirer 211. The evaluation server 500 sends the evaluation result of the evaluator 301 to the moving vehicle 400. Alternatively, the evaluation server 500 may send the evaluation result to a predetermined server on a communication network such as the Internet or to a predetermined e-mail address. The predetermined e-mail address is, for example, an e-mail address of an owner of the moving vehicle 400.

The configuration in FIG. 28 further reduces the required computing resources of the moving vehicle 400 as compared to the configuration in FIG. 26 or 27.

(Fourth Example)

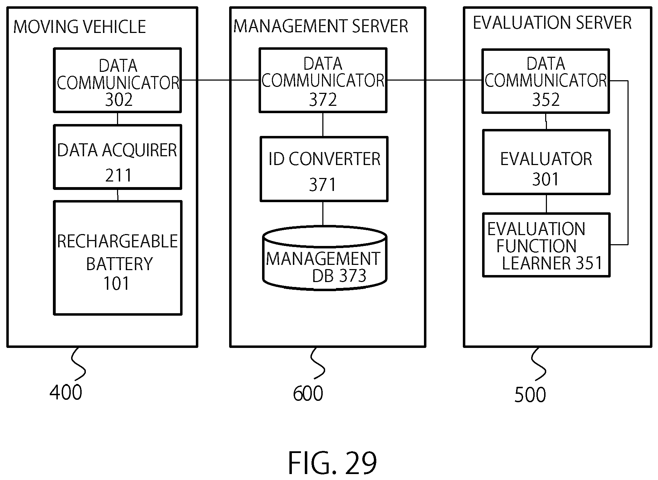

FIG. 29 shows another example in which the rechargeable battery evaluation system in FIG. 12, 20 or 22 is distributed over the moving vehicle 400, a management server 600 (first server) and the evaluation server 500 (second server). The moving vehicle 400 includes the rechargeable battery 101, the data acquirer 211 and the data communicator 302 (first data communicator). The evaluation server 500 includes the data communicator 352 (third data communicator), the evaluator 301 and the evaluation function learner 351. The management server 600 includes an ID converter (identifier determiner) 371, a data communicator 372 (second data communicator) and a management DB 373. The same elements as in FIG. 28 are given the same reference characters, and their descriptions will be omitted as appropriate.

The management server 600 is provided between the moving vehicle 400 and the evaluation server 500. The data communicator 372 of the management server 600 performs wired or wireless communication with the data communicator 302 of the moving vehicle 400 and the data communicator 352 of the evaluation server 500.

The data communicator 302 of the moving vehicle 400 adds identification information (moving vehicle ID) of the moving vehicle 400 to the operation data acquired from the rechargeable battery 101 and sends it to the management server 600. The data communicator 372 of the management server 600 receives the operation data from the moving vehicle 400.

The management DB 373 of the management server 600 stores information in which the moving vehicle ID and an analysis ID are associated with each other in the management DB 373. Furthermore, the management DB 373 may store an e-mail address corresponding to the moving vehicle 400. The e-mail address is, as an example, an e-mail address of an owner of the moving vehicle 400.

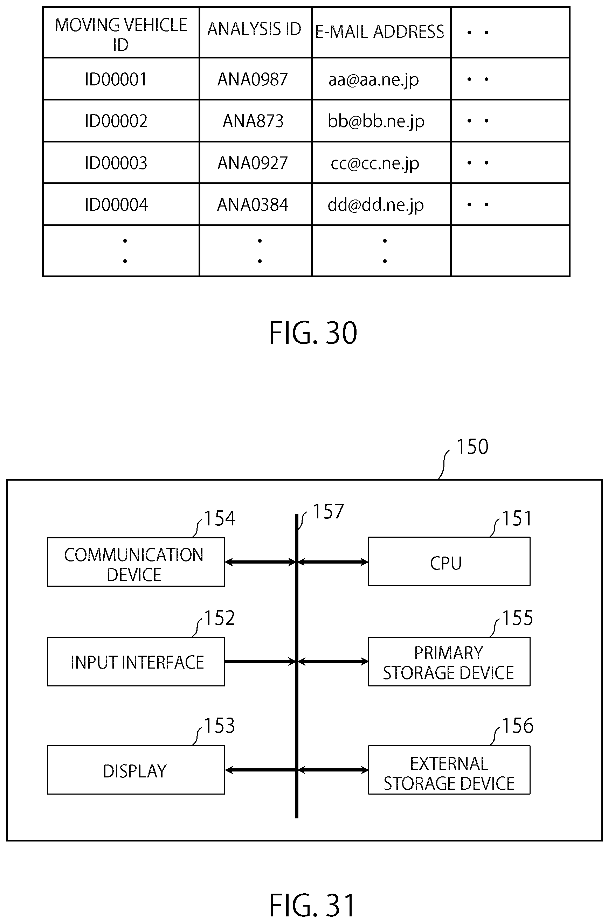

FIG. 30 shows an example of the management DB 373. Moving vehicle IDs, analysis IDs and e-mail addresses are included.

The ID converter 371 determines an analysis ID corresponding to the moving vehicle ID added to the operation data received from the moving vehicle 400. The moving vehicle ID added to the operation data is replaced with the analysis ID. The management server 600 sends the operation data to which the analysis ID is added to the evaluation server 500.

The data communicator 352 of the evaluation server 500 receives the operation data to which the analysis ID is added. The evaluator 301 of the evaluation server 500 evaluates the degradation state of the rechargeable battery 101. The data communicator 352 adds the same analysis ID as the analysis ID added to the operation data to the evaluation result and sends it to the management server 600.

The data communicator 372 of the management server 600 receives the evaluation result from the evaluation server 500. The ID converter 371 finds the moving vehicle ID corresponding to the analysis ID added to the evaluation result in the management DB 373. The data communicator 372 of the management server 600 sends the evaluation result to the moving vehicle 400 having the found moving vehicle ID. The moving vehicle ID may be sent together with the evaluation result. Also, the management server 600 may send the evaluation result to a server on a communication network such as the Internet or may send the evaluation result to the e-mail address corresponding to the moving vehicle ID.

With the configuration in FIG. 29, it is possible to perform evaluation of the rechargeable battery 101 provided with the moving vehicle 400 in the evaluation server 500 without disclosing information identifying the moving vehicle 400 to the evaluation server 500.

(Hardware Configuration)

FIG. 31 shows an example hardware configuration of the rechargeable battery evaluation apparatus 201 according to the embodiments of the present invention. This hardware configuration can be applied to the rechargeable battery evaluation apparatus 201 according to each embodiment described above. The hardware configuration in FIG. 31 is configured as a computer 150. The computer 150 includes a CPU 151, an input interface 152, a display 153, a communication device 154, a primary storage device 155 and an external storage device 156, and these are communicatively connected to each other by a bus 157.

The input interface 152 acquires measurement data of the rechargeable battery 101 via wiring or the like. The input interface 152 may be an operating device by which the user provides instructions to the present apparatus. Examples of the operating device include a keyboard, a mouse and a touch panel. The communication device 154 includes a wireless or wired communicator and performs wired or wireless communication with an EV 200. The measurement data may be acquired via the communication device 154. The input interface 152 and the communication device 154 may be composed of separate circuits such as integrated circuits or may be composed of a single circuit such as an integrated circuit. The display 153 is, for example, a liquid crystal display device, an organic EL display device, a CRT display device or the like. The display 153 corresponds to the evaluation result output device 218 in FIG. 1.

The external storage device 156 includes, for example, storage media such as an HDD, SSD, memory device, CD-R, CD-RW, DVD-RAM, DVD-R and the like. The external storage device 156 stores a program for causing the CPU 151, which is a processor, to execute the functions of the processing elements of the rechargeable battery evaluation apparatus 201. The DBs included in the rechargeable battery evaluation apparatus 201 are also included in the external storage device 156. Although only one external storage device 156 is shown here, there may be a plurality of external storage devices 156.

Under control of the CPU 151, the primary storage device 155 develops a control program stored in the external storage device 156 and stores data required for executing the program, data generated by the execution of the program and the like. The primary storage device 155 includes any memory or storage such as a volatile memory (such as a DRAM or SRAM) or a non-volatile memory (such as a NAND flash memory or MRAM), for example. The control program developed on the primary storage device 155 is executed by the CPU 151, and the functions of the processing elements of the rechargeable battery evaluation apparatus 201 are thereby executed. The DBs included in the rechargeable battery evaluation apparatus 201 may also be included in the primary storage device 155.

While certain embodiments have been described, these embodiments have been presented by way of example only, and are not intended to limit the scope of the inventions. Indeed, the novel embodiments described herein may be embodied in a variety of other forms.

Reference Signs List

| 101: | rechargeable battery |
| 102: | controller |
| 201: | rechargeable battery evaluation apparatus |
| 211: | data acquirer |
| 212: | operation data DB |
| 213: | evaluation target data extractor |
| 214: | OCV curve estimator (relationship information generator) |
| 215: | voltage corrector (first voltage corrector) |
| 216: | SoC range determiner |
| 217: | state evaluator |
| 218: | evaluation result output device |

219: evaluation function DB
231: evaluation function generator
232: reference DB
233: measurement target data extractor
234: evaluation function updater
235: capacity measurement DB
241: SoC corrector
242: SoC_DB
253: voltage corrector (second voltage corrector)
252: ratio DB
301: evaluator
351: evaluation function learner
352: data communicator
302: data communicator
371: ID converter
372: data communicator
373: management DB
400: moving vehicle
500: evaluation server
600: management server
151: CPU
152: input interface
153: display
154: communication device
155: primary storage device
156: external storage device
157: bus

**Claims**

1. An information processing apparatus (201) for estimating a degradation state of a rechargeable battery (101) **characterized in that** the apparatus comprises:

   a first voltage corrector (215) configured to correct a first voltage value of the rechargeable battery according to a difference between the first voltage value and a third voltage value to generate a second voltage value, the first voltage value including one of a charge voltage or discharge voltage, and the third voltage value depending on an amount of charged electricity of the rechargeable battery at the first voltage value;
   a state evaluator (217) configured to evaluate the degradation state of the rechargeable battery based on the second voltage value; and
   a relationship information generator (214) configured to generate first relationship information between the third voltage value and the amount of charged electricity of the rechargeable battery based on data, the data including the first voltage value and the amount of charged electricity, wherein
   the first voltage corrector corrects the first voltage value based on the first relationship information.

2. The information processing apparatus according to claim 1, wherein
   the third voltage value is an estimated value of OCV (Open Circuit Voltage) of the rechargeable battery.

3. The information processing apparatus according to claim 1 or 2, wherein
   the relationship information generator generates a regression function in which the first voltage value is an objective variable and the amount of charged electricity is an explanatory variable, and uses the regression function which is the first relationship information.

4. The information processing apparatus according to claim 1 or 2, wherein
   the relationship information generator generates the first relationship information based on a moving average of the first voltage value.

5. The information processing apparatus according to claim 1 or 2, wherein
   the relationship information generator generates second relationship information between the first voltage value including the charge voltage and the amount of charged electricity, the second relationship information being used as the first relationship information.

6. The information processing apparatus according to any one of claims 1 to 5, wherein
   the state evaluator calculates a standard deviation of the second voltage value and evaluates the state of the rechargeable battery based on the standard deviation.

7. The information processing apparatus according to claim 1, wherein

   the first voltage value is the charge voltage at the amount of charged electricity,
   the third voltage value is the discharge voltage at the amount of charged electricity, and
   the second voltage value is a difference between the first voltage value and the third voltage value.

8. The information processing apparatus according to any one of claims 1 to 7, further comprising:

   a range determiner (216) configured to determine a charged-electricity range targeted for evaluation, wherein
   the state evaluator evaluates the degradation state of the rechargeable battery using the second voltage value at which the amount of charged electricity belongs to the charged-electricity range.

9. The information processing apparatus according to claim 8, wherein
the range determiner determines the charged-electricity range based on a difference between a third voltage value which is an estimated value of OCV of the rechargeable battery and the first voltage value.

10. The information processing apparatus according to claim 8, wherein

the first voltage value and the amount of charged electricity are associated with a temperature of the rechargeable battery or an electric power value for charge or discharge of the rechargeable battery, and
the range determiner calculates, based on the temperature or the electric power value belonging to a plurality of candidates of the charged-electricity range, distribution of the temperature or distribution of the electric power value for each of the candidates, selects at least one candidate from the plurality of candidates based on the distribution, and uses a set of the selected at least one candidate which is the charged-electricity range targeted for evaluation.

11. The information processing apparatus according to any one of claims 1 to 10, further comprising:
a charged-electricity corrector (241) configured to correct the amount of charged electricity of the rechargeable battery at the first voltage value based on reference data, the reference data including a reference electricity storage state and a first amount of charged electricity in the reference electricity storage state.

12. The information processing apparatus according to any one of claims 1 to 11, further comprising:

a second voltage corrector (253) configured to acquire a ratio corresponding to the amount of charged electricity of the rechargeable battery at the first voltage value based on ratio data in which a plurality of amounts of charged electricity and a plurality of ratios are associated with each other and correct the first voltage value according to the ratio, wherein
the first voltage corrector corrects the first voltage value corrected by the second voltage corrector.

13. The information processing apparatus according to any one of claims 1 to 12, wherein
the degradation state of the rechargeable battery is evaluated based on an evaluation function in which a feature based on the second voltage value is an input variable and the state of the rechargeable battery is an output variable.

14. The information processing apparatus according to claim 13, further comprising:
a function generator (231) configured to generate the evaluation function using degradation states of a plurality of rechargeable batteries and features of the plurality of rechargeable batteries.

15. The information processing apparatus according to claim 13 or 14, further comprising:
an evaluation function updater (234) configured to measure the degradation state of the rechargeable battery and update the evaluation function based on the measured degradation state and the output variable of the evaluation function.

16. The information processing apparatus according to any one of claims 8 to 10, wherein
the state evaluator sends, to the rechargeable battery, instruction information instructing to provide information on the amount of charged electricity belonging to the charged-electricity range and the first voltage value.

17. An information processing method for estimating a degradation state of a rechargeable battery (101) **characterized in that** the method comprises following steps:

correcting (S104) a first voltage value of the rechargeable battery according to a difference between the first voltage value and a third voltage value to generate a second voltage value, the first voltage value including one of a charge voltage or discharge voltage, and the third voltage value depending on an amount of charged electricity of the rechargeable battery at the first voltage value;
evaluating (S106) the degradation state of the rechargeable battery based on the second voltage value; and
generating (S103) first relationship information between the third voltage value and the amount of charged electricity of the rechargeable battery based on data, the data including the first voltage value and the amount of charged electricity, wherein
at the correcting step, the first voltage value is corrected based on the first relationship information.

18. A computer program for estimating a degradation state of a rechargeable battery (101) **characterized in that** the program causes a computer to perform processes comprising the following steps:

correcting (S104) a first voltage value of the rechargeable battery according to a difference between the first voltage value and a third voltage value to generate a second voltage value, the first voltage value including one of a charge voltage or discharge voltage; and the third voltage value depending on an amount of charged electricity of the rechargeable battery at the first voltage value;

evaluating (S106) the degradation state of the rechargeable battery based on the second voltage value;

generating (S103) first relationship information between the third voltage value and the amount of charged electricity of the rechargeable battery based on data, the data including the first voltage value and the amount of charged electricity, wherein

at the correcting step, the first voltage value is corrected based on the first relationship information.

19. An information processing system for estimating a degradation state of a rechargeable battery (101) **characterized in that** the system comprises:

a data acquirer (211) configured to acquire data from the rechargeable battery, the data including a first voltage value of the rechargeable battery and an amount of charged electricity of the rechargeable battery at the first voltage value, the first voltage value including one of a charge voltage or discharge voltage; and

an evaluator (301) configured to evaluate the degradation state of the rechargeable battery; wherein

the evaluator includes the information processing apparatus according to any one of claims 1 to 16.

20. The information processing system according to claim 19, further comprising:

a first data communicator (302) configured to send the data; and

a second data communicator (352) configured to receive the data sent from the first data communicator, wherein

the data acquirer and the first data communicator are provided with a moving vehicle (400), and

the second data communicator and the evaluator are provided with a server (500).

21. The information processing system according to claim 19, further comprising:

a first data communicator (302) configured to send the data and a first identifier that identifies a moving vehicle (400) or a user of the moving vehicle;

a second data communicator (372) configured to receive the data and the first identifier;

an identifier determiner (371) configured to determine a second identifier corresponding to the first identifier, wherein

the second data communicator sends the data and the second identifier; and

a third data communicator (352) configured to receive the data and the second identifier from the second data communicator and send an evaluation result of the evaluator and the second identifier to the second data communicator, wherein

the identifier determiner finds the first identifier corresponding to the second identifier received by the second data communicator and sends the data received by the second data communicator to the first data communicator,

the data acquirer and the first data communicator are provided with the moving vehicle,

the second data communicator and the identifier determiner are provided with a first server (600), and

the third data communicator and the evaluator are provided with a second server (500) different from the first server.

**Patentansprüche**

1. Eine Informationsverarbeitungsvorrichtung (201) zum Schätzen eines Degradationszustandes einer wiederaufladbaren Batterie (101), **dadurch gekennzeichnet, dass** die Vorrichtung umfasst:

einen ersten Spannungskorrektor (215), der so konfiguriert ist, dass er einen ersten Spannungswert der wiederaufladbaren Batterie gemäß einer Differenz zwischen dem ersten Spannungswert und einem dritten Spannungswert korrigiert, um einen zweiten Spannungswert zu erzeugen, wobei der erste Spannungswert entweder eine Ladespannung oder eine Entladespannung umfasst und der dritte Spannungswert von einer Menge an geladener Elektrizität der wiederaufladbaren Batterie bei dem ersten Spannungswert abhängt;

einen Zustandsauswerter (217), der so konfiguriert ist, dass er den Degradationszustand der wiederaufladbaren Batterie basierend auf dem zweiten Spannungswert auswertet; und

einen Beziehungsinformationsgenerator (214), der so konfiguriert ist, dass er erste Beziehungsinformationen zwischen dem dritten Spannungswert und der Menge an geladener Elektrizität der wiederaufladbaren Batterie auf der Grundlage von Daten erzeugt, wobei die Daten den ersten Spannungswert und die Menge an geladener Elektrizität umfassen, wobei

der erste Spannungskorrektor den ersten Spannungswert auf der Grundlage der ersten Beziehungsinformation korrigiert.

2. Informationsverarbeitungsvorrichtung nach Anspruch 1, wobei
der dritte Spannungswert ein geschätzter Wert der OCV (Open Circuit Voltage) der wiederaufladbaren Batterie ist.

3. Informationsverarbeitungsvorrichtung nach Anspruch 1 oder 2, wobei
der Beziehungsinformationsgenerator eine Regressionsfunktion erzeugt, in der der erste Spannungswert eine Zielvariable und die Menge des geladenen Stroms eine Erklärungsvariable ist, und die Regressionsfunktion verwendet, die die erste Beziehungsinformation ist.

4. Informationsverarbeitungsvorrichtung nach Anspruch 1 oder 2, wobei
der Beziehungsinformationsgenerator die erste Beziehungsinformation auf der Grundlage eines gleitenden Durchschnitts des ersten Spannungswertes erzeugt.

5. Informationsverarbeitungsvorrichtung nach Anspruch 1 oder 2, wobei
der Beziehungsinformationsgenerator eine zweite Beziehungsinformation zwischen dem ersten Spannungswert, der die Ladespannung umfasst, und der Menge der geladenen Elektrizität erzeugt, wobei die zweite Beziehungsinformation als die erste Beziehungsinformation verwendet wird.

6. Informationsverarbeitungsvorrichtung nach einem der Ansprüche 1 bis 5, wobei
der Zustandsauswerter eine Standardabweichung des zweiten Spannungswertes berechnet und den Zustand der wiederaufladbaren Batterie basierend auf der Standardabweichung auswertet.

7. Informationsverarbeitungsvorrichtung nach Anspruch 1, wobei

der erste Spannungswert die Ladespannung bei der Menge des geladenen Stroms ist,
der dritte Spannungswert die Entladespannung bei der Menge des geladenen Stroms ist, und
der zweite Spannungswert eine Differenz zwischen dem ersten Spannungswert und dem dritten Spannungswert ist.

8. Informationsverarbeitungsvorrichtung nach einem der Ansprüche 1 bis 7, ferner umfassend:

einen Bereichsbestimmer (216), der dazu ausgebildet ist, einen zu bewertenden Ladestrombereich zu bestimmen, wobei
der Zustandsauswerter den Degradationszustand der wiederaufladbaren Batterie unter Verwendung des zweiten Spannungswertes auswertet, bei dem die geladene Elektrizitätsmenge zu dem Ladestrombereich gehört.

9. Informationsverarbeitungsvorrichtung nach Anspruch 8, wobei
der Bereichsbestimmer den Ladestrombereich auf der Grundlage einer Differenz zwischen einem dritten Spannungswert, der ein geschätzter Wert des OCV der wiederaufladbaren Batterie ist, und dem ersten Spannungswert bestimmt.

10. Informationsverarbeitungsvorrichtung nach Anspruch 8, wobei

der erste Spannungswert und die geladene Strommenge mit einer Temperatur der wiederaufladbaren Batterie oder einem elektrischen Leistungswert zum Laden oder Entladen der wiederaufladbaren Batterie verknüpft sind, und
der Bereichsbestimmer auf der Grundlage der Temperatur oder des elektrischen Leistungswerts, die zu einer Vielzahl von Kandidaten des Ladestrombereichs gehören, die Verteilung der Temperatur oder die Verteilung des elektrischen Leistungswerts für jeden der Kandidaten berechnet, mindestens einen Kandidaten aus der Vielzahl von Kandidaten auf der Grundlage der Verteilung auswählt und eine Menge des ausgewählten mindestens einen Kandidaten verwendet, die der für die Auswertung anvisierte Ladestrombereich ist.

11. Informationsverarbeitungsvorrichtung nach einem der Ansprüche 1 bis 10, die ferner umfasst:
einen Ladestromkorrektor (241), der so konfiguriert ist, dass er die Menge an geladenem Strom der wiederaufladbaren Batterie bei dem ersten Spannungswert auf der Grundlage von Referenzdaten korrigiert, wobei die Referenzdaten einen Referenzstromspeicherzustand und eine erste Menge an geladenem Strom in dem Referenzstromspeicherzustand umfassen.

12. Informationsverarbeitungsvorrichtung nach einem der Ansprüche 1 bis 11, ferner umfassend:

einen zweiten Spannungskorrektor (253), der so konfiguriert ist, dass er ein Verhältnis erfasst, das der Menge an geladener Elektrizität der wiederaufladbaren Batterie bei dem ersten Spannungswert auf der Grundlage von Verhältnisdaten entspricht, in denen eine Vielzahl von Mengen an geladener Elektrizität und eine Vielzahl von Verhältnissen miteinander verknüpft sind, und den ersten Spannungswert gemäß dem Verhältnis korrigiert, wobei
der erste Spannungskorrektor den ersten Spannungswert korrigiert, der durch den zweiten Spannungskorrektor korrigiert wurde.

13. Informationsverarbeitungsvorrichtung nach einem der Ansprüche 1 bis 12, wobei
der Degradationszustand der wiederaufladbaren Batterie auf der Grundlage einer Bewertungsfunktion bewertet wird, in der ein auf dem zweiten Spannungswert basierendes Merkmal eine Eingangsgröße und der Zustand der wiederaufladbaren Batterie eine Ausgangsgröße ist.

14. Informationsverarbeitungsvorrichtung nach Anspruch 13, ferner umfassend:
einen Funktionsgenerator (231), der so konfiguriert ist, dass er die Bewertungsfunktion unter Verwendung von Degradationszuständen einer Vielzahl von wiederaufladbaren Batterien und Merkmalen der Vielzahl von wiederaufladbaren Batterien erzeugt.

15. Informationsverarbeitungsvorrichtung nach Anspruch 13 oder 14, ferner umfassend:
einen Aktualisierer (234) für die Bewertungsfunktion, der so konfiguriert ist, dass er den Degradationszustand der wiederaufladbaren Batterie misst und die Bewertungsfunktion basierend auf dem gemessenen Degradationszustand und der Ausgangsvariablen der Bewertungsfunktion aktualisiert.

16. Informationsverarbeitungsvorrichtung nach einem der Ansprüche 8 bis 10, wobei
der Zustandsauswerter an die wiederaufladbare Batterie Anweisungsinformationen sendet, die anweisen, Informationen über die zum Ladestrombereich gehörende Menge an geladenem Strom und den ersten Spannungswert vorzusehen.

17. Informationsverarbeitungsverfahren zur Abschätzung eines Degradationszustandes einer wiederaufladbaren Batterie (101), **dadurch gekennzeichnet, dass** das Verfahren folgende Schritte umfasst:

Korrigieren (S104) eines ersten Spannungswertes der wiederaufladbaren Batterie gemäß einer Differenz zwischen dem ersten Spannungswert und einem dritten Spannungswert, um einen zweiten Spannungswert zu erzeugen, wobei der erste Spannungswert entweder eine Ladespannung oder eine Entladespannung umfasst und der dritte Spannungswert von einer Menge an geladener Elektrizität der wiederaufladbaren Batterie bei dem ersten Spannungswert abhängt;
Auswerten (S106) des Verschlechterungszustands der wiederaufladbaren Batterie auf der Grundlage des zweiten Spannungswerts; und
Erzeugen (S103) erster Beziehungsinformationen zwischen dem dritten Spannungswert und der Menge an geladener Elektrizität der wiederaufladbaren Batterie auf der Grundlage von Daten, wobei die Daten den ersten Spannungswert und die Menge an geladener Elektrizität umfassen, wobei
bei dem Korrekturschritt der erste Spannungswert auf der Grundlage der ersten Beziehungsinformation korrigiert wird.

18. Ein Computerprogramm zum Schätzen eines Degradationszustandes einer wiederaufladbaren Batterie (101), **dadurch gekennzeichnet, dass** das Programm einen Computer veranlasst, Prozesse durchzuführen, die die folgenden Schritte umfassen:

Korrigieren (S104) eines ersten Spannungswertes der wiederaufladbaren Batterie gemäß einer Differenz zwischen dem ersten Spannungswert und einem dritten Spannungswert, um einen zweiten Spannungswert zu erzeugen, wobei der erste Spannungswert entweder eine Ladespannung oder eine Entladespannung umfasst; und der dritte Spannungswert von einer Menge an geladener Elektrizität der wiederaufladbaren Batterie bei dem ersten Spannungswert abhängt;
Auswerten (S106) des Degradationszustandes der wiederaufladbaren Batterie auf der Grundlage des zweiten Spannungswertes;
Erzeugen (S103) erster Beziehungsinformationen zwischen dem dritten Spannungswert und der Menge an geladener Elektrizität der wiederaufladbaren Batterie auf der Grundlage von Daten, wobei die Daten den ersten Spannungswert und die Menge an geladener Elektrizität umfassen, wobei
bei dem Korrekturschritt der erste Spannungswert auf der Grundlage der ersten Beziehungsinformation korrigiert wird.

19. Ein Informationsverarbeitungssystem zum Abschätzen eines Degradationszustandes einer wiederaufladbaren Batterie (101), **dadurch gekennzeichnet, dass** das System umfasst:

einen Datenerfasser (211), der so konfiguriert ist, dass er Daten von der wiederaufladbaren Batterie erfasst, wobei die Daten einen ersten Spannungswert der wiederaufladbaren Batterie und eine Menge an geladener Elektrizität der wiederaufladbaren Batterie bei dem ersten Spannungswert umfassen, wobei der erste Spannungswert entweder eine Ladespannung oder eine Entladespannung umfasst; und
einen Auswerter (301), der so konfiguriert ist, dass er den Degradationszustand der wiederaufladbaren Batterie auswertet; wobei
die Auswerteeinrichtung die Informationsverarbeitungsvorrichtung nach einem der Ansprüche 1 bis 16 umfasst.

20. Informationsverarbeitungssystem nach Anspruch 19, ferner umfassend:

einen ersten Kommunikator (302), der zum Senden der Daten konfiguriert ist; und
einen zweiten Datenkommunikator (352), der so konfiguriert ist, dass er die von dem ersten Kommunikator gesendeten Daten empfängt, wobei
der Datenerfasser und der erste Datenkommunikator mit einem fahrenden Fahrzeug (400) vorgesehen sind, und
der zweite Kommunikator und der Auswerter mit einem Server (500) vorgesehen sind.

21. Informationsverarbeitungssystem nach Anspruch 19, ferner umfassend:

einen ersten Kommunikator (302), der so konfiguriert ist, dass er die Daten und einen ersten Identifikator, der ein sich bewegendes Fahrzeug (400) oder einen Anwender des sich bewegenden Fahrzeugs identifiziert, sendet;
einen zweiten Kommunikator (372), der so konfiguriert ist, dass er die Daten und den ersten Identifikator empfängt;
eine Identifikator-Bestimmungseinrichtung (371), die so konfiguriert ist, dass sie einen zweiten Identifikator bestimmt, die dem ersten Identifikator zugehört, wobei
der zweite Kommunikator für Daten die Daten und das zweite Merkmal sendet; und
einen dritten Kommunikator (352), der so konfiguriert ist, dass er die Daten und den zweiten Identifikator von dem zweiten Kommunikator empfängt und ein Auswertungsergebnis des Auswerters und den zweiten Identifikator an den zweiten Kommunikator sendet, wobei
der Identifikator-Bestimmer den ersten Identifikator-Bestimmer findet, die den vom zweiten Kommunikator empfangenen zweiten Identifikator zugehört, und die vom zweiten Kommunikator empfangenen Daten an den ersten Datenkommunikator sendet,
der Datenerfasser und der erste Datenkommunikator mit dem fahrenden Fahrzeug vorgesehen sind,
der zweite Kommunikator und der Identifikator-Bestimmer mit einem ersten Server (600) vorgesehen sind, und
der dritte Kommunikator und der Auswerter sind mit einem zweiten Server (500) vorgesehen, der sich vom ersten Server unterscheidet.

**Revendications**

1. Un appareil de traitement d'information (201) destiné à estimer un état de dégradation d'une batterie rechargeable (101), **caractérisé en ce que** l'appareil comprend :

un premier correcteur de tension (215) configuré pour corriger une première valeur de tension de la batterie rechargeable en fonction d'une différence entre la première valeur de tension et une troisième valeur de tension afin de générer une deuxième valeur de tension, la première valeur de tension comprenant une parmi une tension de charge ou une tension de décharge, et la troisième valeur de tension dépendant d'une quantité d'électricité chargée de la batterie rechargeable à la première valeur de tension ;
un évaluateur d'état (217) configuré pour évaluer l'état de dégradation de la batterie rechargeable sur la base de la deuxième valeur de tension ; et
un générateur d'information de relation (214) configuré pour générer des premières informations de relation entre la troisième valeur de tension et la quantité d'électricité chargée de la batterie rechargeable sur la base de données, les données comprenant la première valeur de tension et la quantité d'électricité chargée, dans lequel
le premier correcteur de tension corrige la première valeur de tension sur la base des premières informations de relation.

2. L'appareil de traitement d'information selon la revendication 1, dans lequel
la troisième valeur de tension est une valeur estimée de la tension en circuit ouvert (OCV) de la batterie rechargeable.

3. L'appareil de traitement d'information selon la revendication 1 ou 2, dans lequel
le générateur d'information de relation génère une fonction de régression dans laquelle la première valeur de tension est une variable objective et la quantité d'électricité chargée est une variable explicative, et utilise la fonction de régression qui est la première information de relation.

4. L'appareil de traitement d'information selon la revendication 1 ou 2, dans lequel
le générateur d'information de relation génère les premières informations de relation sur la base d'une moyenne glissante de la première valeur de tension.

**5.** L'appareil de traitement d'information selon la revendication 1 ou 2, dans lequel
le générateur d'information de relation génère des deuxièmes informations de relation entre la première valeur de tension comprenant la tension de charge et la quantité d'électricité chargée, les deuxièmes informations de relation étant utilisées comme premières informations de relation.

**6.** L'appareil de traitement d'information selon l'une quelconque des revendications 1 à 5, dans lequel l'évaluateur d'état calcule un écart type de la deuxième valeur de tension et évalue l'état de la batterie rechargeable sur la base de l'écart type.

**7.** L'appareil de traitement d'information selon la revendication 1, dans lequel

la première valeur de tension est la tension de charge à la quantité d'électricité chargée,
la troisième valeur de tension est la tension de décharge à la quantité d'électricité chargée, et
la deuxième valeur de tension est une différence entre la première valeur de tension et la troisième valeur de tension.

**8.** L'appareil de traitement d'information selon l'une quelconque des revendications 1 à 7, comprenant en outre :

un dispositif de détermination de plage (216) configuré pour déterminer une plage d'électricité chargée ciblée pour évaluation, dans lequel l'évaluateur d'état évalue l'état de dégradation de la batterie rechargeable en utilisant la deuxième valeur de tension à laquelle la quantité d'électricité chargée appartient à la plage d'électricité chargée.

**9.** L'appareil de traitement d'information selon la revendication 8, dans lequel
le dispositif de détermination de plage détermine la plage d'électricité chargée sur la base d'une différence entre une troisième valeur de tension qui est une valeur estimée de la tension à circuit ouvert (OCV) de la batterie rechargeable et la première valeur de tension.

**10.** L'appareil de traitement d'informations selon la revendication 8, dans lequel

la première valeur de tension et la quantité d'électricité chargée sont associées à une température de la batterie rechargeable ou à une valeur de puissance électrique pour la charge ou la décharge de la batterie rechargeable, et
le dispositif de détermination de plage calcule, sur la base de la température ou de la valeur de puissance électrique appartenant à une pluralité de candidats de la plage d'électricité chargée, une distribution de la température ou une distribution de la valeur de puissance électrique pour chacun des candidats, sélectionne au moins un candidat parmi la pluralité de candidats sur la base de la distribution, et utilise un ensemble du au moins un candidat sélectionné qui est la plage d'électricité chargée ciblée pour évaluation.

**11.** L'appareil de traitement d'information selon l'une quelconque des revendications 1 à 10, comprenant en outre :
un correcteur d'électricité chargée (241) configuré pour corriger la quantité d'électricité chargée de la batterie rechargeable à la première valeur de tension sur la base de données de référence, les données de référence comprenant un état de stockage d'électricité de référence et une première quantité d'électricité chargée dans l'état de stockage d'électricité de référence.

**12.** L'appareil de traitement d'information selon l'une quelconque des revendications 1 à 11, comprenant en outre :

un deuxième correcteur de tension (253) configuré pour acquérir un rapport correspondant à la quantité d'électricité chargée de la batterie rechargeable à la première valeur de tension sur la base de données de rapport dans lesquelles une pluralité de quantités d'électricité chargée et une pluralité de rapports sont associées les unes aux autres et pour corriger la première valeur de tension en fonction du rapport, dans lequel
le premier correcteur de tension corrige la première valeur de tension corrigée par le deuxième correcteur de tension.

**13.** L'appareil de traitement d'information selon l'une quelconque des revendications 1 à 12, dans lequel l'état de dégradation de la batterie rechargeable est évalué sur la base d'une fonction d'évaluation dans laquelle une caractéristique basée sur la deuxième valeur de tension est une variable d'entrée et l'état de la batterie rechargeable est une variable de sortie.

**14.** L'appareil de traitement d'information selon la revendication 13, comprenant en outre :
un générateur de fonction (231) configuré pour générer la fonction d'évaluation en utilisant des états de dégradation d'une pluralité de batteries rechargeables et des caractéristiques de la pluralité de batteries rechargeables.

**15.** L'appareil de traitement d'information selon la revendication 13 ou 14, comprenant en outre :
un dispositif de mise à jour de fonction d'évaluation (234) configuré pour mesurer l'état de dégradation de la batterie rechargeable et mettre à jour la fonction d'évaluation sur la base de l'état de dégradation mesuré et de la variable de sortie de la fonction d'évaluation.

16. L'appareil de traitement d'information selon l'une quelconque des revendications 8 à 10, dans lequel l'évaluateur d'état envoie, à la batterie rechargeable, des informations d'instruction indiquant de fournir des informations sur la quantité d'électricité chargée appartenant à la plage d'électricité chargée et la première valeur de tension.

17. Procédé de traitement d'information pour estimer un état de dégradation d'une batterie rechargeable (101), **caractérisé en ce que** le procédé comprend les étapes suivantes :

corriger (S104) une première valeur de tension de la batterie rechargeable en fonction d'une différence entre la première valeur de tension et une troisième valeur de tension afin de générer une deuxième valeur de tension, la première valeur de tension comprenant une parmi une tension de charge ou une tension de décharge, et la troisième valeur de tension dépendant d'une quantité d'électricité chargée de la batterie rechargeable à la première valeur de tension ;
évaluer (S106) l'état de dégradation de la batterie rechargeable sur la base de la deuxième valeur de tension ; et
générer (S103) des premières informations de relation entre la troisième valeur de tension et la quantité d'électricité chargée de la batterie rechargeable sur la base de données, les données comprenant la première valeur de tension et la quantité d'électricité chargée, dans lequel à l'étape de correction, la première valeur de tension est corrigée sur la base des premières informations de relation.

18. Programme informatique destiné à estimer un état de dégradation d'une batterie rechargeable (101), **caractérisé en ce que** le programme amène un ordinateur à exécuter des processus comprenant les étapes suivantes :
corriger (S104) une première valeur de tension de la batterie rechargeable en fonction d'une différence entre la première valeur de tension et une troisième valeur de tension afin de générer une deuxième valeur de tension, la première valeur de tension comprenant une parmi une tension de charge ou une tension de décharge ; et la troisième valeur de tension dépendant d'une quantité d'électricité chargée de la batterie rechargeable à la première valeur de tension ;

évaluer (S106) l'état de dégradation de la batterie rechargeable sur la base de la deuxième valeur de tension ;
générer (S103) des premières informations de relation entre la troisième valeur de tension et la quantité d'électricité chargée de la batterie rechargeable sur la base de données, les données comprenant la première valeur de tension et la quantité d'électricité chargée, dans lequel à l'étape de correction, la première valeur de tension est corrigée sur la base des premières informations de relation.

19. Système de traitement d'information pour estimer un état de dégradation d'une batterie rechargeable (101), **caractérisé en ce que** le système comprend :

un dispositif d'acquisition de données (211) configuré pour acquérir des données provenant de la batterie rechargeable, les données comprenant une première valeur de tension de la batterie rechargeable et une quantité d'électricité chargée dans la batterie rechargeable à la première valeur de tension, la première valeur de tension comprenant une parmi une tension de charge ou une tension de décharge ; et
un évaluateur (301) configuré pour évaluer l'état de dégradation de la batterie rechargeable ; dans lequel
l'évaluateur comprend l'appareil de traitement d'information selon l'une quelconque des revendications 1 à 16.

20. Le système de traitement d'information selon la revendication 19, comprenant en outre :

un premier communicateur de données (302) configuré pour envoyer les données ; et
un deuxième communicateur de données (352) configuré pour recevoir les données envoyées par le premier communicateur de données, dans lequel

le dispositif d'acquisition de données et le premier communicateur de données sont fournis avec un véhicule en mouvement (400), et
le deuxième communicateur de données et l'évaluateur sont fournis avec un serveur (500).

21. Le système de traitement d'information selon la revendication 19, comprenant en outre :

un premier communicateur de données (302) configuré pour envoyer les données et un premier identifiant qui identifie un véhicule en mouvement (400) ou un utilisateur du véhicule en mouvement ;

un deuxième communicateur de données (372) configuré pour recevoir les données et le premier identifiant ;

un déterminateur d'identifiant (371) configuré pour déterminer un deuxième identifiant correspondant au premier identifiant, dans lequel le deuxième communicateur de données envoie les données et le deuxième identifiant ; et

un troisième communicateur de données (352) configuré pour recevoir les données et le deuxième identifiant provenant du deuxième communicateur de données et envoyer un résultat d'évaluation de l'évaluateur et le deuxième identifiant au deuxième communicateur de données, dans lequel

le déterminateur d'identifiant trouve le premier identifiant correspondant au deuxième identifiant reçu par le deuxième communicateur de données et envoie les données reçues par le deuxième communicateur de données au premier communicateur de données,

le dispositif d'acquisition de données et le premier communicateur de données sont fournis avec le véhicule en mouvement,

le deuxième communicateur de données et le déterminateur d'identifiant sont fournis avec un premier serveur (600), et

le troisième communicateur de données et l'évaluateur sont équipés d'un deuxième serveur (500) différent du premier serveur.

FIG. 1

RECHARGEABLE BATTERY

| BATTERY UNIT 1 | BATTERY UNIT2 | BATTERY UNIT N |
|---|---|---|
| MODULE 1-1 | MODULE 2-1 | MODULE N-1 |
| MODULE 1-2 | MODULE 2-2 | MODULE N-2 |
| ⋮ | ⋮ | ⋮ |
| MODULE 1-M | MODULE 2-M | MODULE N-M |

. . .

FIG. 2

MODULE

| CELL | CELL | CELL | . . . | CELL |
|---|---|---|---|---|
| ⋮ | ⋮ | ⋮ | | ⋮ |
| CELL | CELL | CELL | | CELL |

FIG. 3

| BATTERY ID | TIME | VOLTAGE | SoC | ELECTRIC POWER | TEMPERATURE | · · |
|---|---|---|---|---|---|---|
| BATTERY 1 | 2018/3/10 10:00:00 | 30.3 | 80.5 | 1280 | 25.2 | · · |
| BATTERY 1 | 2018/3/10 10:00:01 | 30.1 | 80.3 | 1280 | 25.2 | · · |
| BATTERY 1 | 2018/3/10 10:00:02 | 30.1 | 80.2 | 1281 | 25.3 | · · |
| BATTERY 1 | 2018/3/10 10:00:03 | 30.2 | 80.0 | 1282 | 25.3 | · · |
| BATTERY 1 | · · · | · · · | · · · | · · · | · · · | |

FIG. 4

FIG. 5

FIG. 6

FIG. 7

FIG. 8

FIG. 9

STATE EVALUATION PROCEDURE

ACQUIRE OPERATION DATA BY DATA ACQUIRER — S101

EXTRACT OPERATION DATA TARGETED FOR EVALUATION BY EVALUATION TARGET DATA EXTRACTOR — S102

ESTIMATE OCV CURVE WITH RESPECT TO SoC BASED ON EVALUATION TARGET DATA BY OCV CURVE ESTIMATOR — S103

GENERATE CORRECTED VOLTAGE VALUE CORRESPONDING TO DIFFERENCE BETWEEN OCV VALUE AND VOLTAGE VALUE BY FIRST VOLTAGE CORRECTOR — S104

DETERMINE SoC RANGE USED FOR EVALUATION BY SoC RANGE DETERMINER — S105

EVALUATE DEGRADATION STATE BY USING STANDARD DEVIATION OF CORRECTED VOLTAGE VALUES AND EVALUATION FUNCTION BY STATE EVALUATOR — S106

OUTPUT EVALUATION RESULT BY EVALUATION RESULT OUTPUT DEVICE — S107

END

FIG. 10

FIG. 11

FIG. 12

| BATTERY ID | TIME | VOLTAGE | SoC | ELECTRIC POWER | TEMPERATURE | · · |
|---|---|---|---|---|---|---|
| BATTERY A | 2018/3/10 10:00:00 | 30.3 | 80.5 | 1280 | 25.2 | · · |
| BATTERY A | 2018/3/10 10:00:01 | 30.1 | 80.3 | 1280 | 25.2 | · · |
| BATTERY A | 2018/3/10 10:00:02 | 30.1 | 80.2 | 1281 | 25.3 | · · |
| BATTERY A | 2018/3/10 10:00:03 | 30.2 | 80.0 | 1282 | 25.3 | · · |
|  | · · | · · | · · | · · | · · |  |

| BATTERY ID | SOH |
|---|---|
| BATTERY A | 0.98 |
| BATTERY B | 0.72 |
| BATTERY C | 0.92 |
| BATTERY D | 0.87 |
| · · | · · |

# FIG. 13

| SoH | FV VALUE | AVERAGE ELECTRIC POWER | ELECTRIC POWER STANDARD DEVIATION | AVERAGE TEMPERATURE | TEMPERATURE STANDARD DEVIATION | · · |
|---|---|---|---|---|---|---|
| 0.98 | 10.2 | 1247.2 | 414.2 | 42.2 | 3.3 | · · |
| 0.72 | 20.3 | 1245.2 | 445.2 | 34.2 | 4.5 | · · |
| 0.92 | 12.2 | 1244.1 | 444.2 | 43.1 | 4.6 | · · |
| 0.87 | 14.2 | 1248.5 | 446.1 | 34.2 | 4.2 | · · |
| | ⋮ | ⋮ | ⋮ | ⋮ | ⋮ | |

FIG. 14

FIG. 15

| BATTERY ID | TIME | SoH | CHARGE RATE | TEMPERATURE AVERAGE | TEMPERATURE STANDARD DEVIATION | ‥ |
|---|---|---|---|---|---|---|
| BATTERY 1 | 2018/3/10 10:00 | 0.98 | 1C CONSTANT CURRENT | 42.2 | 3.3 | ‥ |
| BATTERY 1 | 2018/9/10 16:00 | 0.72 | | 34.2 | 4.5 | ‥ |
| BATTERY 2 | 2018/3/10 10:00 | 0.92 | | 43.1 | 4.6 | ‥ |
| BATTERY 2 | 2018/9/10 16:00 | 0.87 | | 34.2 | 4.2 | ‥ |
| | | | ⋮ | ⋮ | ⋮ | |

FIG. 16

SoH

D1
○
Y1

D2
○
Y2

ESTIMATED VALUE
OF SoH

19/1      19/2      19/3      19/4     TIME [MONTH]

## FIG. 17

EVALUATION FUNCTION GENERATING PROCEDURE

READ TRAINING DATA FROM REFERENCE DB

MEASURE SoH BASED ON DATA IN CAPACITY
MEASUREMENT PERIOD BY MEASUREMENT
TARGET DATA EXTRACTOR

STORE EVALUATION FUNCTION
IN EVALUATION FUNCTION DB

END

## FIG. 18

```
┌─────────────────────────────────────────────┐
│   EVALUATION FUNCTION UPDATING PROCEDURE     │
└─────────────────────────────────────────────┘
                      │
                      ▼
┌─────────────────────────────────────────────┐
│  EXTRACT DATA IN CAPACITY MEASUREMENT PERIOD │
│    BY MEASUREMENT TARGET DATA EXTRACTOR      │
└─────────────────────────────────────────────┘
                      │
                      ▼
┌─────────────────────────────────────────────┐
│ MEASURE SoH BASED ON DATA IN CAPACITY MEASUREMENT │
│   PERIOD BY MEASUREMENT TARGET DATA EXTRACTOR │
└─────────────────────────────────────────────┘
                      │
                      ▼
┌─────────────────────────────────────────────┐
│  UPDATE EVALUATION FUNCTION BASED ON CAPACITY │
│ MEASUREMENT DB BY EVALUATION FUNCTION UPDATER │
└─────────────────────────────────────────────┘
                      │
                      ▼
                ┌───────────┐
                │    END    │
                └───────────┘
```

FIG. 19

FIG. 20

```
         ( STATE EVALUATION PROCEDURE )
                      │
                      ▼
  ┌─────────────────────────────────────────┐
  │ ACQUIRE OPERATION DATA BY DATA ACQUIRER  │──S101
  └─────────────────────────────────────────┘
                      │
                      ▼
  ┌─────────────────────────────────────────┐
  │ EXTRACT OPERATION DATA TARGETED FOR      │
  │ EVALUATION BY EVALUATION TARGET DATA     │──S102
  │ EXTRACTOR                                │
  └─────────────────────────────────────────┘
                      │
                      ▼
  ┌─────────────────────────────────────────┐
  │ CORRECT SoC BY SoC CORRECTOR             │──S111
  └─────────────────────────────────────────┘
                      │
                      ▼
  ┌─────────────────────────────────────────┐
  │ ESTIMATE OCV CURVE WITH RESPECT TO SoC   │
  │ BASED ON EVALUATION TARGET DATA BY OCV   │──S103
  │ CURVE ESTIMATOR                          │
  └─────────────────────────────────────────┘
                      │
                      ▼
  ┌─────────────────────────────────────────┐
  │ GENERATE CORRECTED VOLTAGE VALUE         │
  │ CORRESPONDING TO DIFFERENCE BETWEEN OCV  │──S104
  │ VALUE AND VOLTAGE VALUE BY FIRST         │
  │ VOLTAGE CORRECTOR                        │
  └─────────────────────────────────────────┘
                      │
                      ▼
  ┌─────────────────────────────────────────┐
  │ DETERMINE SoC RANGE USED FOR             │
  │ EVALUATION BY SoC RANGE DETERMINER       │──S105
  └─────────────────────────────────────────┘
                      │
                      ▼
  ┌─────────────────────────────────────────┐
  │ EVALUATE DEGRADATION STATE BY USING      │
  │ STANDARD DEVIATION OF CORRECTED VOLTAGE  │──S106
  │ VALUES AND EVALUATION FUNCTION BY STATE  │
  │ EVALUATOR                                │
  └─────────────────────────────────────────┘
                      │
                      ▼
  ┌─────────────────────────────────────────┐
  │ OUTPUT EVALUATION RESULT BY              │
  │ EVALUATION RESULT OUTPUT DEVICE          │──S107
  └─────────────────────────────────────────┘
                      │
                      ▼
                  ( END )
```

FIG. 21

FIG. 22

```
        ( STATE EVALUATION PROCEDURE )
                      |
                      v
  +------------------------------------------+
  |  ACQUIRE OPERATION DATA BY DATA ACQUIRER |——S101
  +------------------------------------------+
                      |
                      v
  +------------------------------------------+
  | EXTRACT OPERATION DATA TARGETED FOR EVALUATION |——S102
  |  BY EVALUATION TARGET DATA EXTRACTOR     |
  +------------------------------------------+
                      |
                      v
  +------------------------------------------+
  |      CORRECT SoC BY SoC CORRECTOR        |——S111
  +------------------------------------------+
                      |
                      v
  +------------------------------------------+
  | ESTIMATE OCV CURVE WITH RESPECT TO SoC BASED ON |——S103
  | EVALUATION TARGET DATA BY OCV CURVE ESTIMATOR |
  +------------------------------------------+
                      |
                      v
  +------------------------------------------+
  |  CORRECT VOLTAGE VALUE BASED ON RATIO DB |——S121
  |      BY SECOND VOLTAGE CORRECTOR         |
  +------------------------------------------+
                      |
                      v
  +------------------------------------------+
  | GENERATE CORRECTED VOLTAGE VALUE CORRESPONDING |——S104
  |     TO DIFFERENCE BETWEEN OCV VALUE AND  |
  |   VOLTAGE VALUE BY FIRST VOLTAGE CORRECTOR |
  +------------------------------------------+
                      |
                      v
  +------------------------------------------+
  |       DETERMINE SoC RANGE USED FOR       |——S105
  |    EVALUATION BY SoC RANGE DETERMINER    |
  +------------------------------------------+
                      |
                      v
  +------------------------------------------+
  | EVALUATE DEGRADATION STATE BY USING STANDARD |——S106
  | DEVIATION OF CORRECTED VOLTAGE VALUES AND |
  |  EVALUATION FUNCTION BY STATE EVALUATOR  |
  +------------------------------------------+
                      |
                      v
  +------------------------------------------+
  |      OUTPUT EVALUATION RESULT BY         |——S107
  |   EVALUATION RESULT OUTPUT DEVICE        |
  +------------------------------------------+
                      |
                      v
                  (  END  )
```

FIG. 23

FIG. 24

FIG. 25

400

FIG. 26

MOVING VEHICLE

EVALUATOR
301

DATA
COMMUNICATOR
302

DATA ACQUIRER
211

RECHARGEABLE
BATTERY
101

400

DATA
COMMUNICATOR
352

EVALUATION
FUNCTION
LEARNER 351

500

FIG. 27

MOVING VEHICLE

DATA
COMMUNICATOR
302

DATA ACQUIRER
211

RECHARGEABLE
BATTERY
101

400

EVALUATION SERVER

DATA
COMMUNICATOR
352

EVALUATOR
301

EVALUATION
FUNCTION
LEARNER 351

500

FIG. 28

| MOVING VEHICLE | MANAGEMENT SERVER | EVALUATION SERVER |
|---|---|---|
| DATA COMMUNICATOR 302 | DATA COMMUNICATOR 372 | DATA COMMUNICATOR 352 |
| DATA ACQUIRER 211 | ID CONVERTER 371 | EVALUATOR 301 |
| RECHARGEABLE BATTERY 101 | MANAGEMENT DB 373 | EVALUATION FUNCTION LEARNER 351 |

400 600 500

# FIG. 29

| MOVING VEHICLE ID | ANALYSIS ID | E-MAIL ADDRESS | · · |
|---|---|---|---|
| ID00001 | ANA0987 | aa@aa.ne.jp | · · |
| ID00002 | ANA873 | bb@bb.ne.jp | · · |
| ID00003 | ANA0927 | cc@cc.ne.jp | · · |
| ID00004 | ANA0384 | dd@dd.ne.jp | · · |
| ⋮ | ⋮ | ⋮ | |

## FIG. 30

FIG. 31

**EP 4 123 322 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6313502 B
- US 20190181510 A1